# EUROPEAN PATENT APPLICATION

(11) **EP 4 404 250 A1**
(43) Date of publication of application: **24.07.2024**
(21) Application number: 22869614.2
(22) Date of filing: 25.03.2022
(51) Int. Cl.: H01L 21/76, H01L 27/146, H04N 25/70

(54) **LIGHT DETECTING DEVICE, METHOD FOR MANUFACTURING LIGHT DETECTING DEVICE, AND ELECTRONIC INSTRUMENT**

(30) Priority: 16.09.2021 JP 2021151390
(71) Applicant: Sony Semiconductor Solutions Corporation, Atsugi-shi, Kanagawa 243-0014 (JP)
(72) Inventor: FURUSHO, Takaaki, Kikuchi-gun, Kumamoto 869-1102 (JP); EDA, Kentaro, Kikuchi-gun, Kumamoto 869-1102 (JP); TAZAKI, Masayuki, Kikuchi-gun, Kumamoto 869-1102 (JP); UEHARA, Mutsuo, Atsugi-shi, Kanagawa 243-0014 (JP); SAITO, Suguru, Atsugi-shi, Kanagawa 243-0014 (JP)
(74) Representative: MFG Patentanwälte Meyer-Wildhagen Meggle-Freund Gerhard PartG mbB
(86) International application number: PCT/JP2022/014483
(87) International publication number: WO 2023/042462

(57) **Abstract**

A light detection device capable of suppressing the worsening of noise characteristics is provided. The light detection device includes a semiconductor layer having photoelectric conversion regions, one surface of the semiconductor layer forming a light incident surface, the other surface of the semiconductor layer forming an element forming surface, a trench positioned to partition the photoelectric conversion regions and penetrating the semiconductor layer in a direction of thickness thereof, and a separation part formed in the trench and including a first separation part and a second separation part, the first separation part being positioned on the side of the light incident surface, the second separation part being positioned on the side of the element forming surface. A first surface of the second separation part on the side of the first separation part faces a first material.

## Description

### [Technical Field]

The present technology (technology according to the present disclosure) relates to a light detection device, a method of manufacturing the light detection device, and electronic equipment. More particularly, this technology relates to a light detection device having photoelectric conversion regions partitioned therein, a method of manufacturing the light detection device, and electronic equipment.

### [Background Art]

In recent years, pixels have been manufactured in ever-smaller sizes in light detection devices such as back-illuminated CMOS image sensors. Meanwhile, some image sensors have been proposed with structures in which deep trenches completely separate pixels from one another such that electrons or holes generated within photodiodes will not be leaked out to other pixels (e.g., see PTL 1).

### [Citation List]

### [Patent Literature]

[PTL 1]
PCT Patent Publication No. WO2019/093150

### [Summary]

### [Technical Problem]

In the case where the pixels are separated from each other by the trenches, a film doped with a p-type dopant or having negative fixed charges is formed over trench side walls so as to suppress a dark current being leaked out of the trench side walls.

The present technology aims to provide a light detection device capable of suppressing the worsening of noise characteristics, a method of manufacturing the light detection device, and electronic equipment.

### [Solution to Problem]

According to one embodiment of the present technology, there is provided a light detection device including a semiconductor layer having photoelectric conversion regions, one surface of the semiconductor layer forming a light incident surface, the other surface of the semiconductor layer forming an element forming surface, a trench positioned to partition the photoelectric conversion regions and penetrating the semiconductor layer in a direction of thickness thereof, and a separation part formed in the trench and including a first separation part and a second separation part, the first separation part being positioned on the side of the light incident surface, the second separation part being positioned on the side of the element forming surface. A first surface of the second separation part on the side of the first separation part faces a first material.

According to another embodiment of the present technology, there is provided a method of manufacturing a light detection device, including forming a trench in a position to partition photoelectric conversion regions in a semiconductor layer from the side of an element forming surface thereof, stacking, in the trench, a sacrificial layer and a first material in this order in a direction of thickness of the semiconductor layer, the first material being a material of which an etching rate relative to a selected etchant is lower than that of a material constituting the sacrificial layer, exposing the sacrificial layer from the side of a light incident surface opposite to the side of the element forming surface, removing the sacrificial layer while leaving the first material intact, by use of the selected etchant, and embedding a material different from the material of the sacrificial layer into the trench from the side of the light incident surface.

According to a further embodiment of the present technology, there is provided electronic equipment including the above-described light detection device and an optical system that causes the light detection device to form an image of image light from a subject.

### [Brief Description of Drawings]

[FIG. 1]

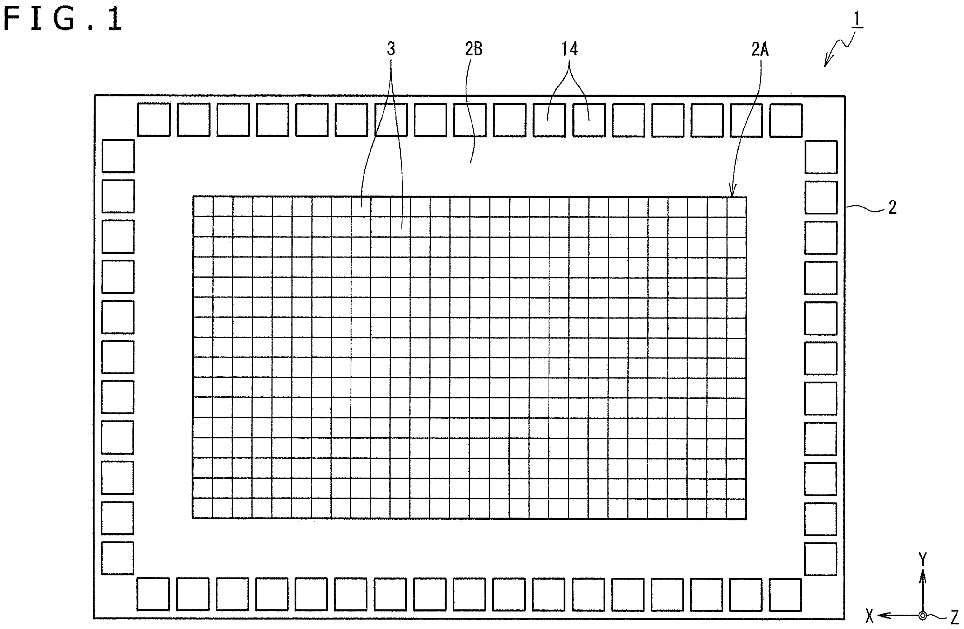

   FIG. 1 is a chip layout diagram depicting a configuration example of a light detection device according to a first embodiment of the present technology.
[FIG. 2]

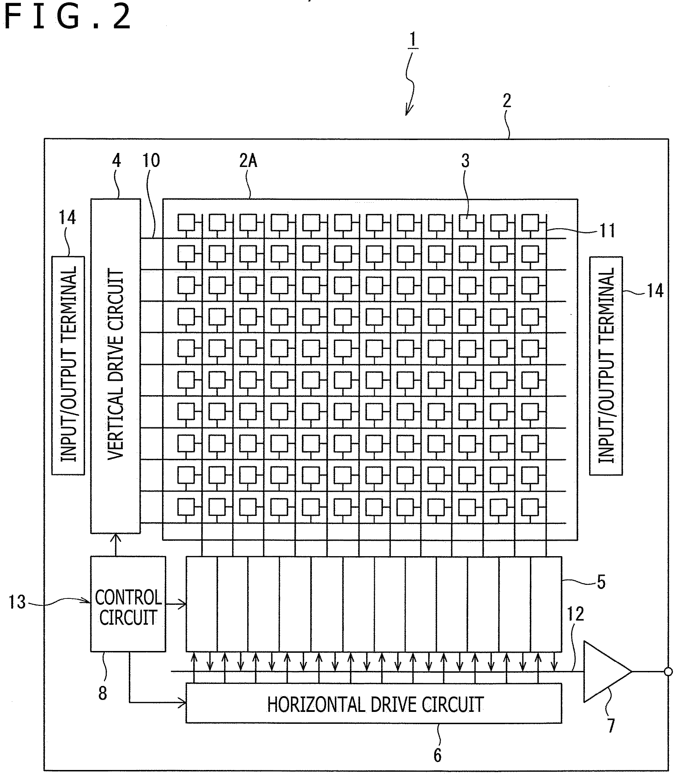

   FIG. 2 is a block diagram depicting the configuration example of the light detection device according to the first embodiment of the present technology.
[FIG. 3]

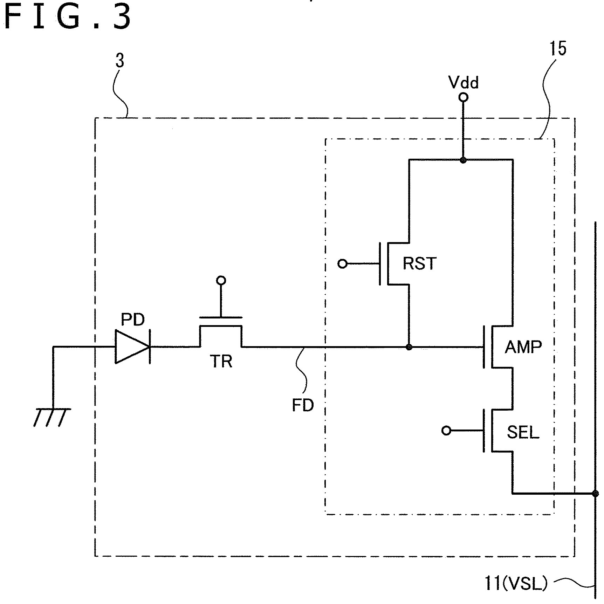

   FIG. 3 is an equivalent circuit diagram of a pixel of the light detection device according to the first embodiment of the present technology.
[FIG. 4]

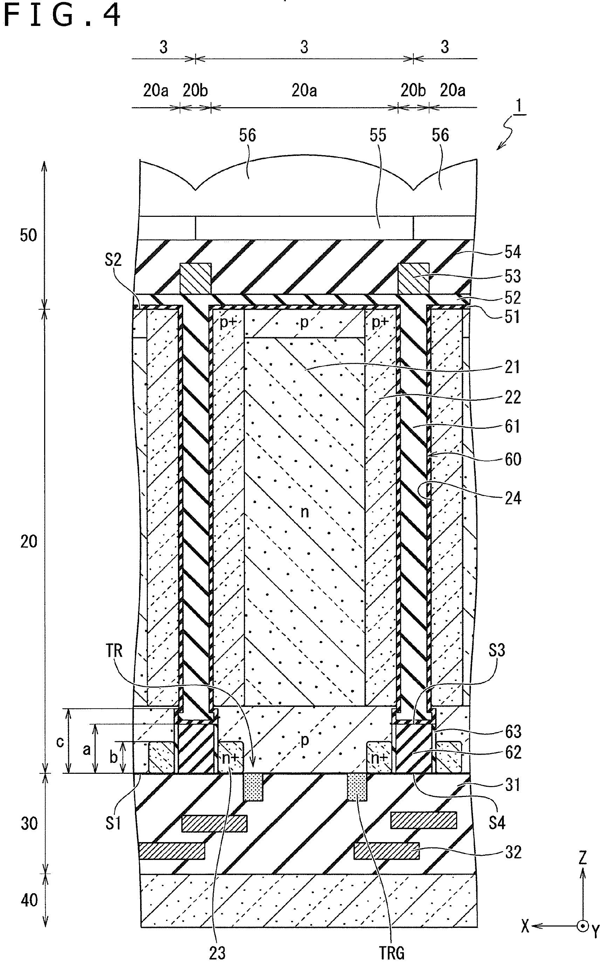

   FIG. 4 is a longitudinal sectional view depicting a cross-section structure of a pixel of the light detection device according to the first embodiment of the present technology.
[FIG. 5A]

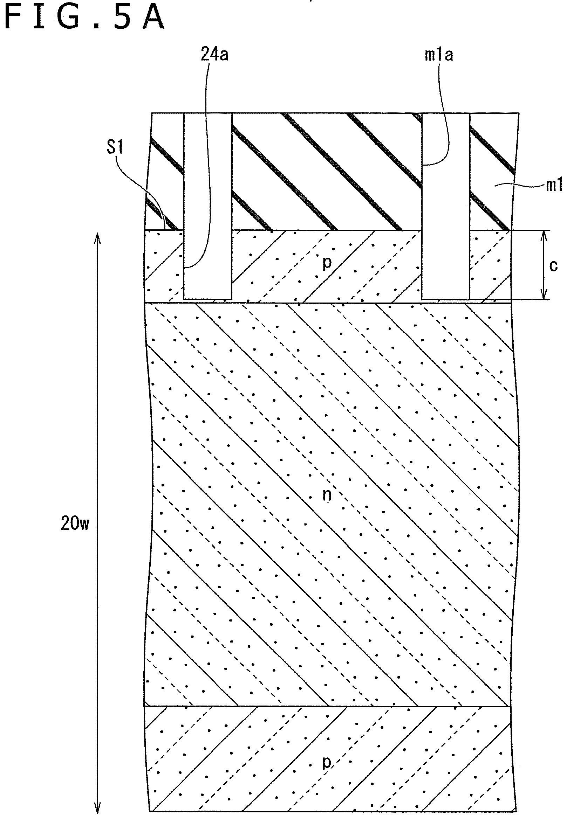

   FIG. 5A is a process sectional view schematically depicting a method of manufacturing the light detection device according to the first embodiment of the present technology.
[FIG. 5B]

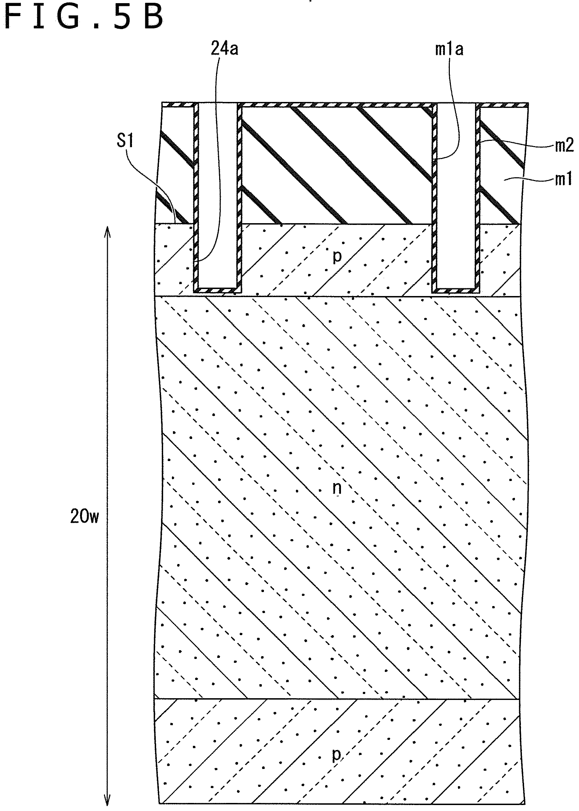

   FIG. 5B is a process sectional view continued from FIG. 5A.
[FIG. 5C]

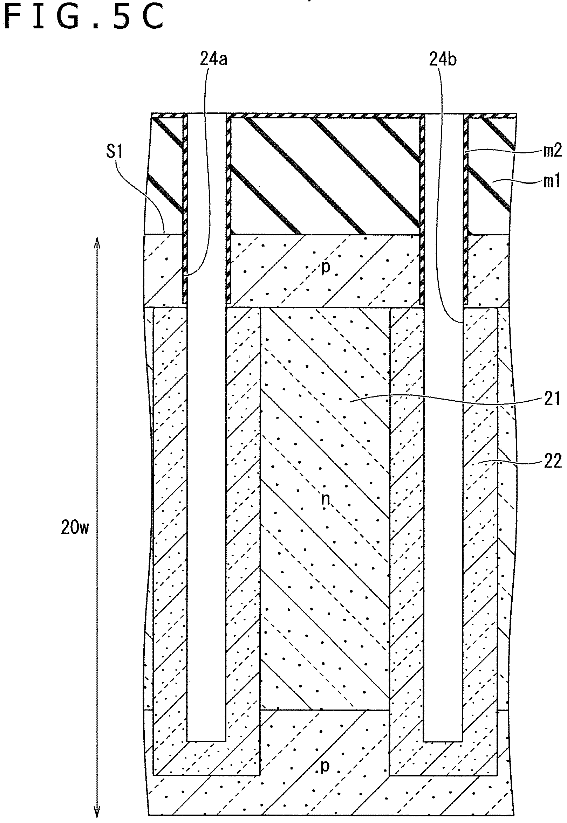

   FIG. 5C is a process sectional view continued from FIG. 5B.
[FIG. 5D]

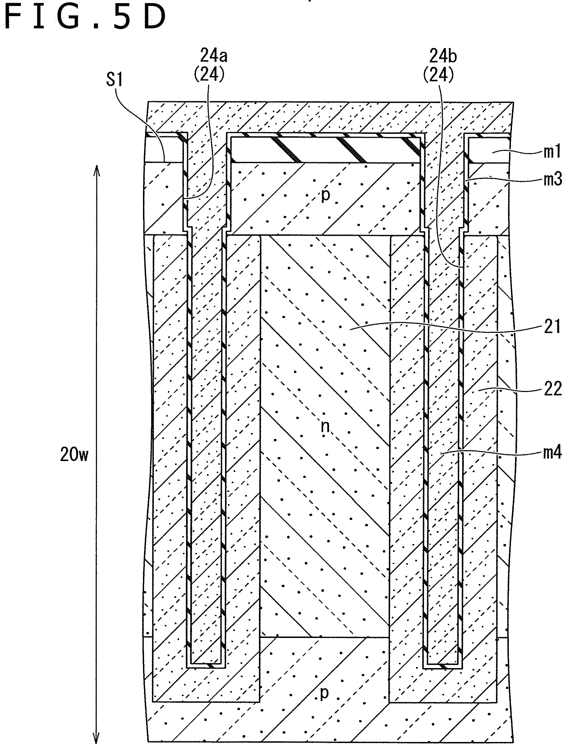

   FIG. 5D is a process sectional view continued from FIG. 5C.
[FIG. 5E]

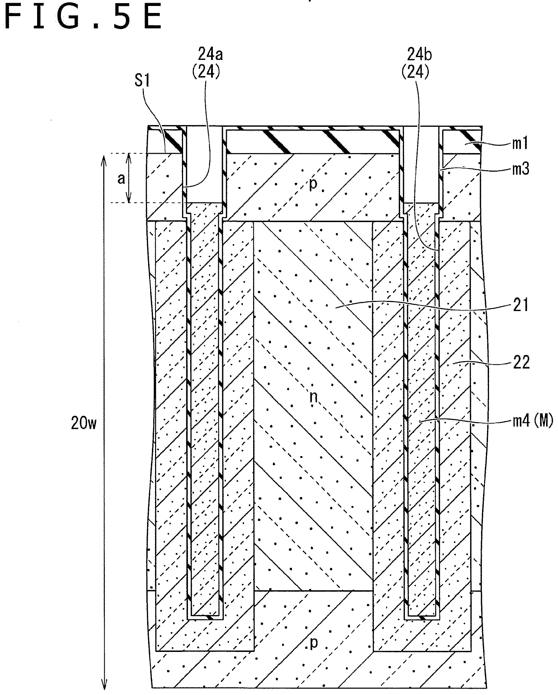

   FIG. 5E is a process sectional view continued from FIG. 5D.
[FIG. 5F]

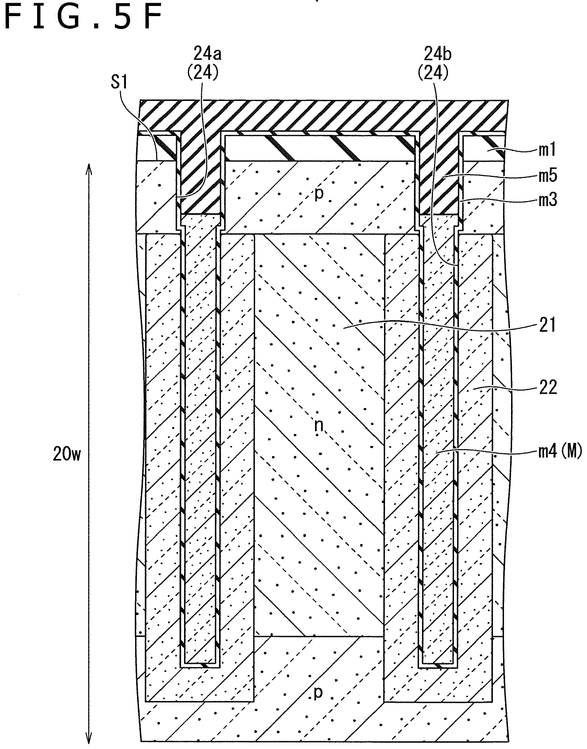

   FIG. 5F is a process sectional view continued from FIG. 5E.
[FIG. 5G]

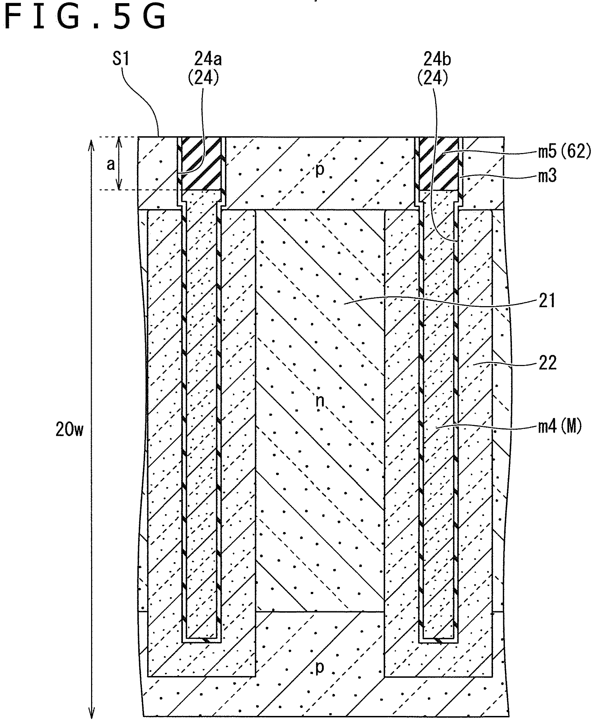

   FIG. 5G is a process sectional view continued from FIG. 5F.
[FIG. 5H]

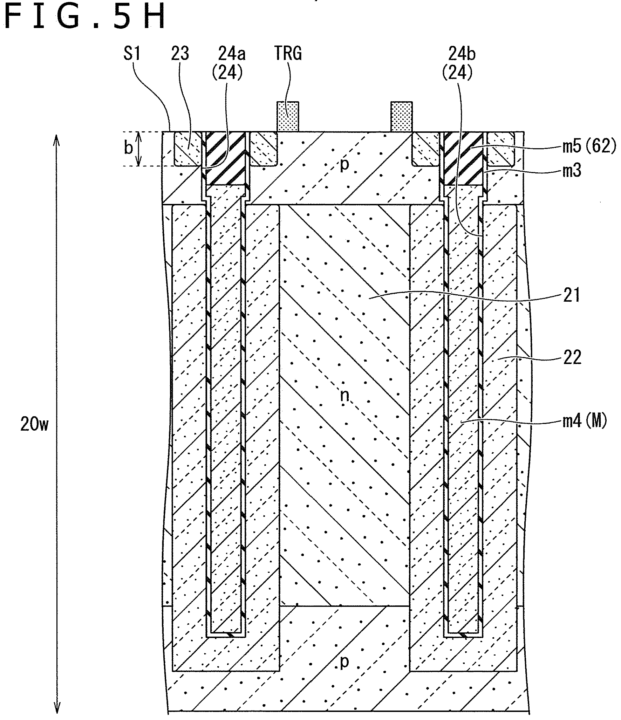

   FIG. 5H is a process sectional view continued from FIG. 5G.
[FIG. 5I]

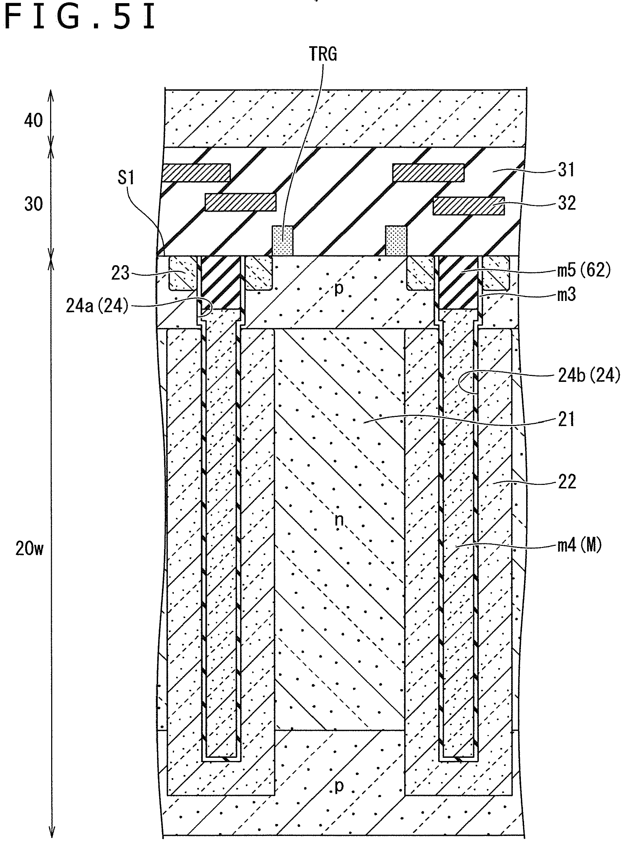

   FIG. 5I is a process sectional view continued from FIG. 5H.
[FIG. 5J]

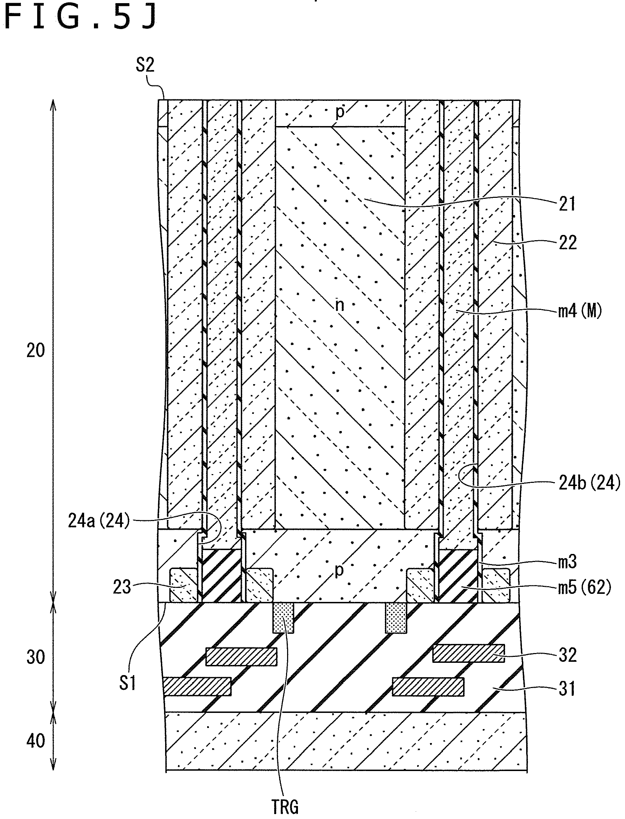

   FIG. 5J is a process sectional view continued from FIG. 5I.
[FIG. 5K]

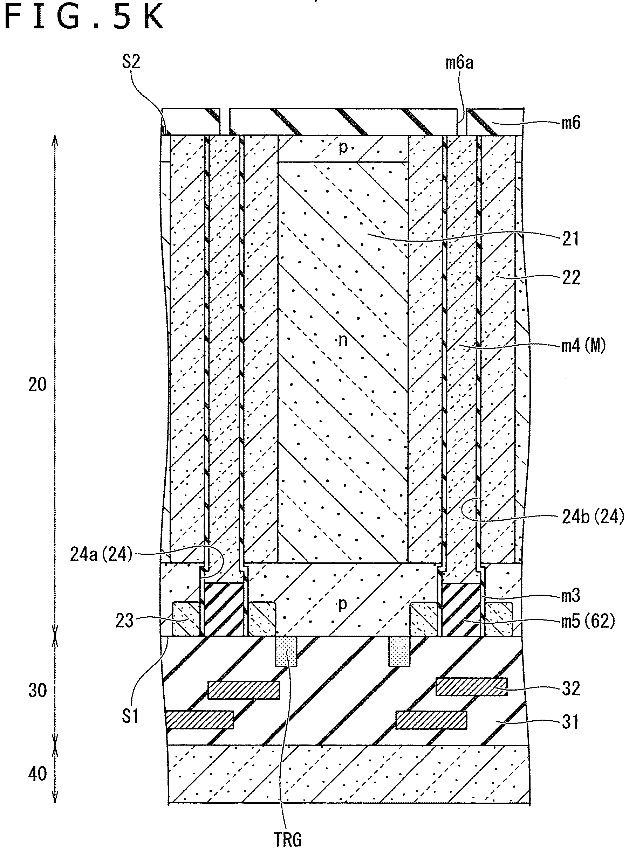

   FIG. 5K is a process sectional view continued from FIG. 5J.
[FIG. 5L]

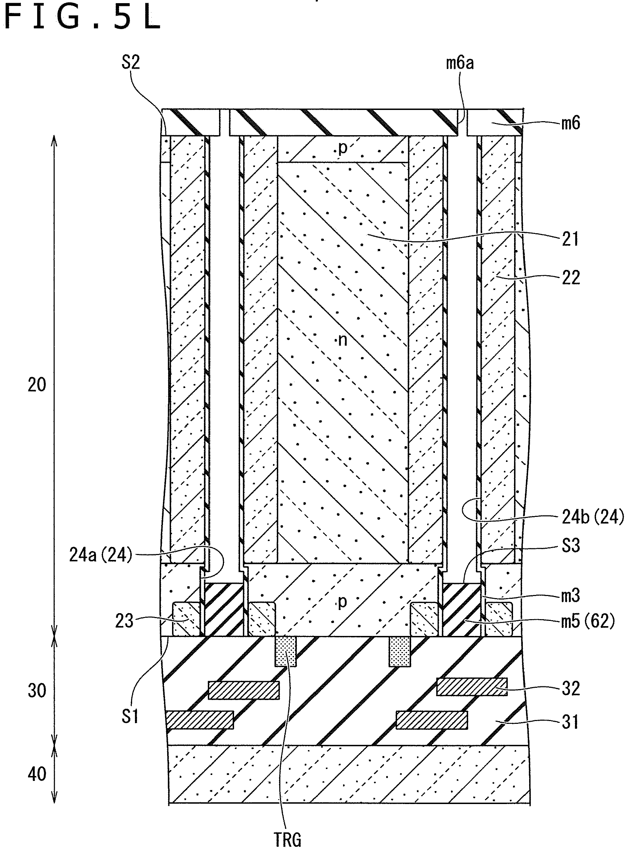

   FIG. 5L is a process sectional view continued from FIG. 5K.
[FIG. 5M]

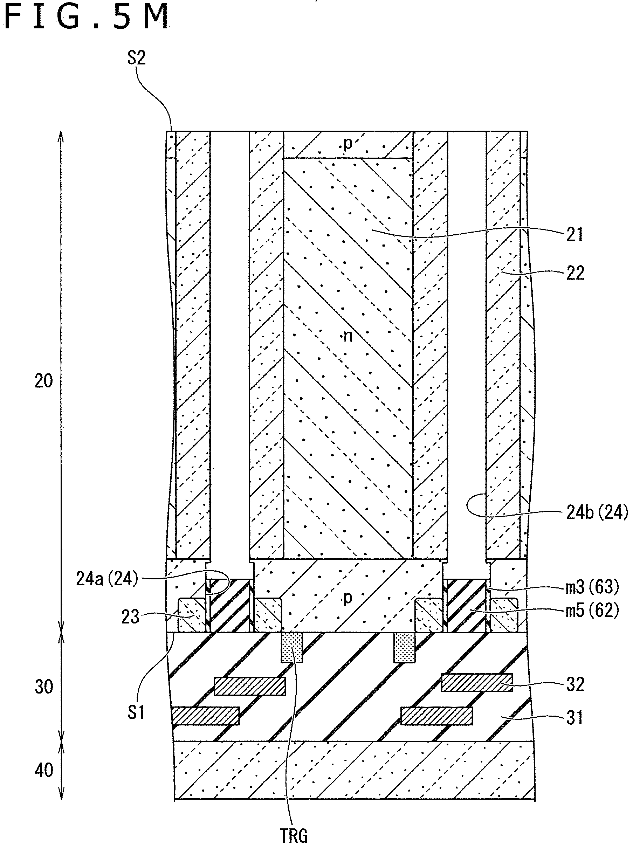

   FIG. 5M is a process sectional view continued from FIG. 5L.
[FIG. 5N]

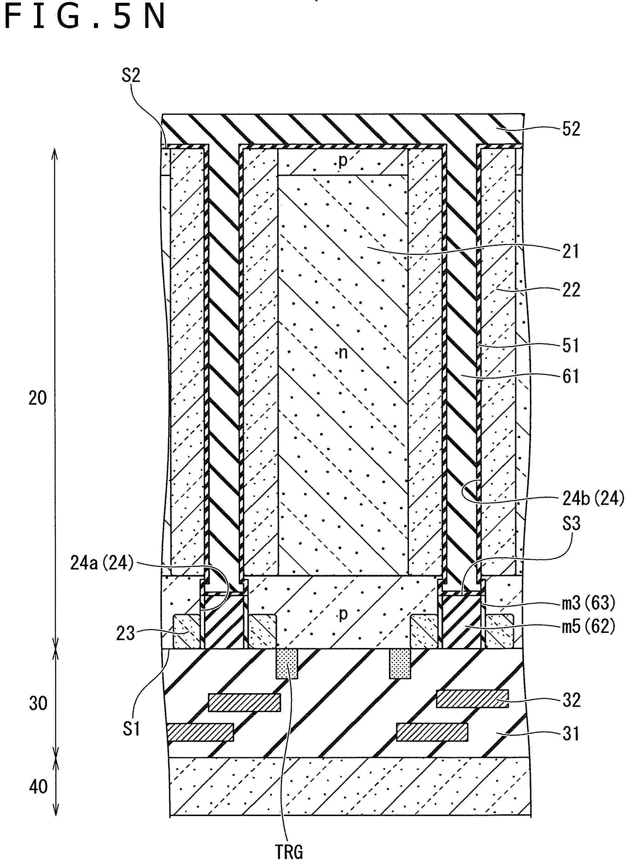

   FIG. 5N is a process sectional view continued from FIG. 5M.
[FIG. 6]

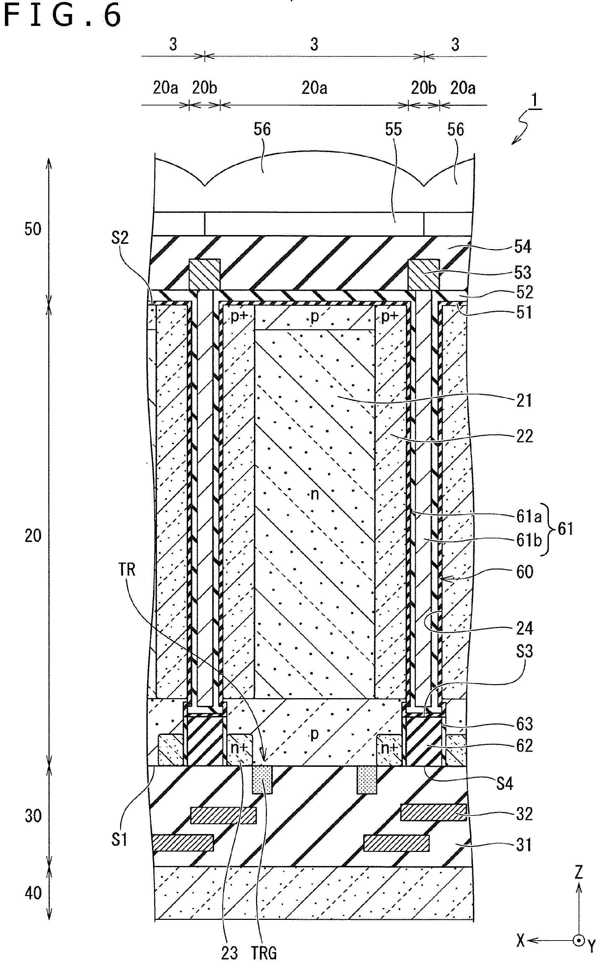

   FIG. 6 is a longitudinal sectional view depicting a cross-section structure of a pixel of a light detection device according to a modification example 1-1 of the first embodiment of the present technology.
[FIG. 7]

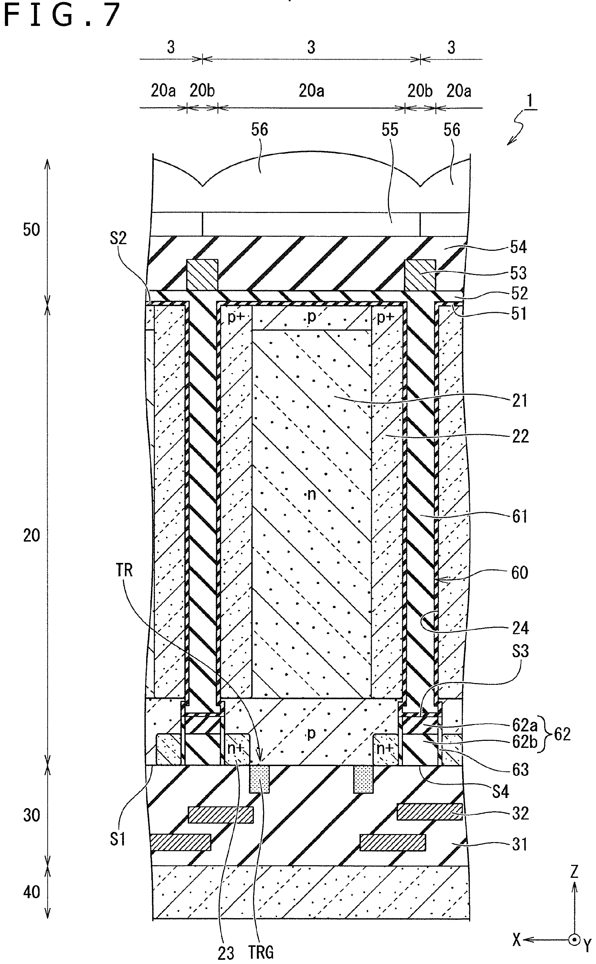

   FIG. 7 is a longitudinal sectional view depicting a cross-section structure of a pixel of a light detection device according to a modification example 1-2 of the first embodiment of the present technology.
[FIG. 8]

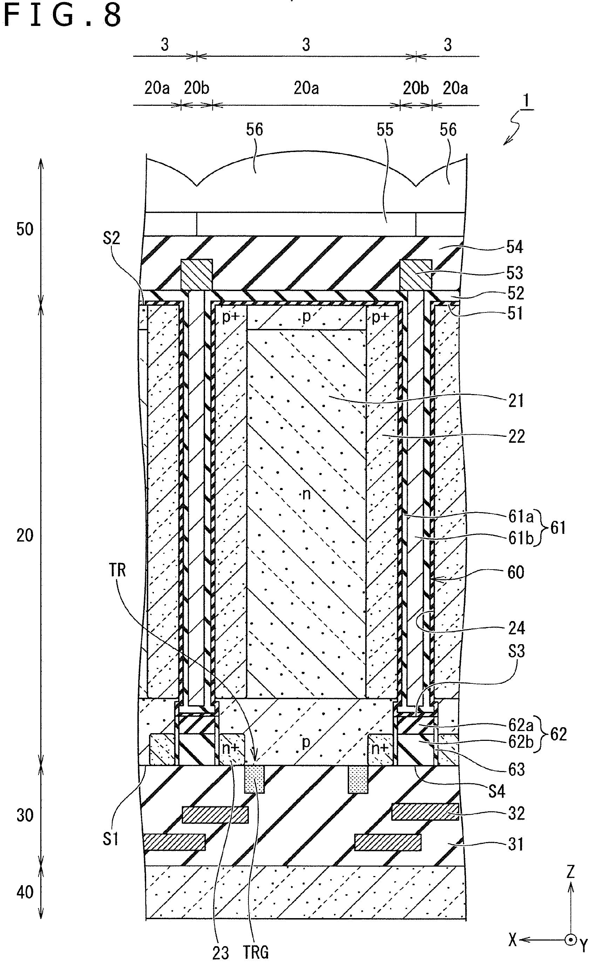

   FIG. 8 is a longitudinal sectional view depicting a cross-section structure of a pixel of a light detection device according to a modification example 1-3 of the first embodiment of the present technology.
[FIG. 9A]

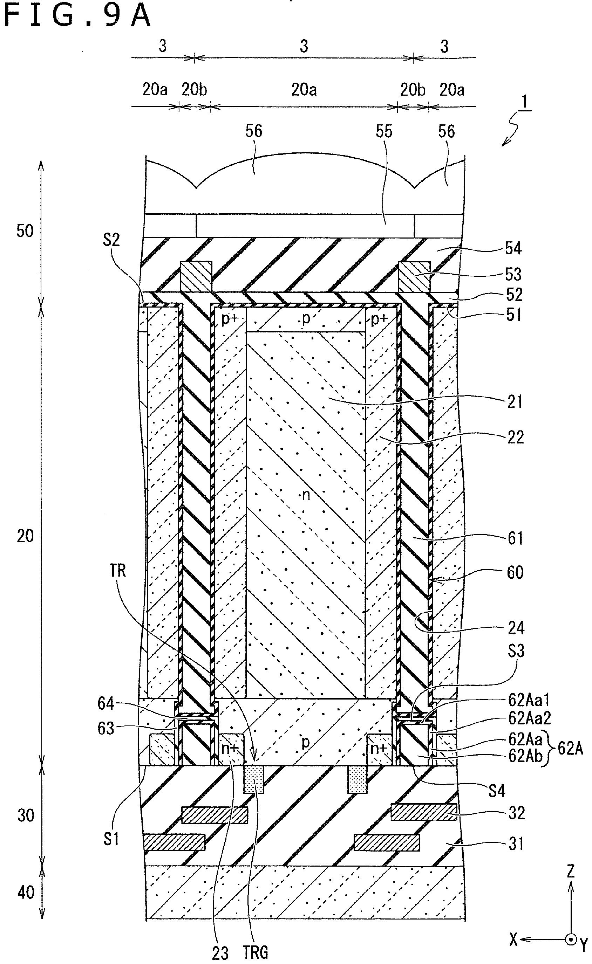

   FIG. 9A is a longitudinal sectional view depicting a cross-section structure of a pixel of a light detection device according to a second embodiment of the present technology.
[FIG. 9B]

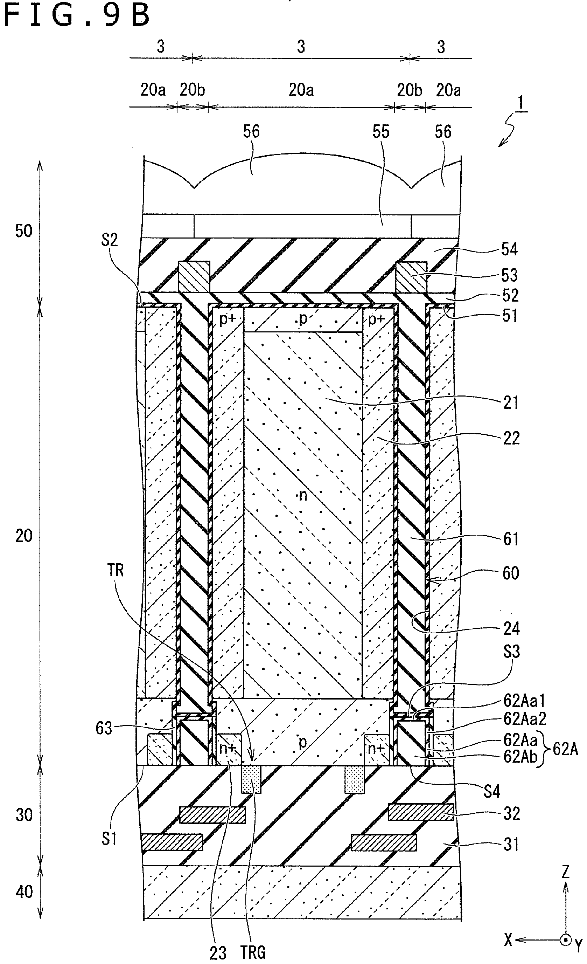

   FIG. 9B is a longitudinal sectional view depicting another cross-section structure of a pixel of the light detection device according to the second embodiment of the present technology.
[FIG. 10A]

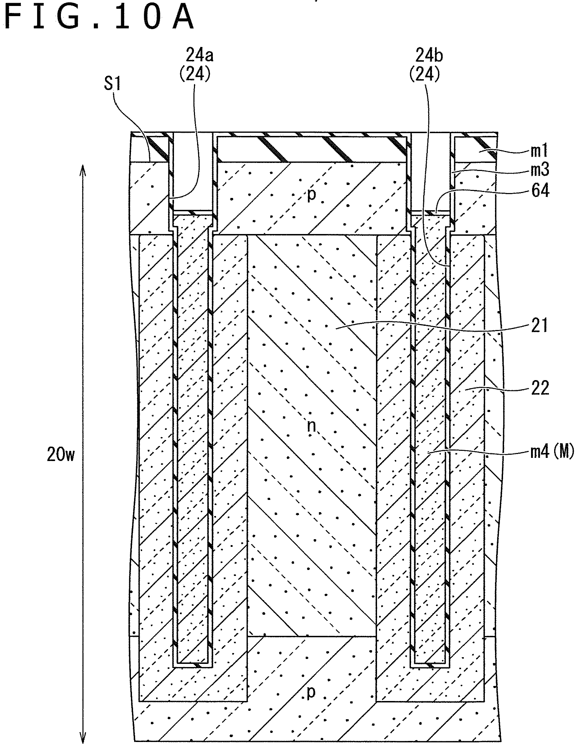

   FIG. 10A is a process sectional view schematically depicting a method of manufacturing the light detection device according to the second embodiment of the present technology.
[FIG. 10B]

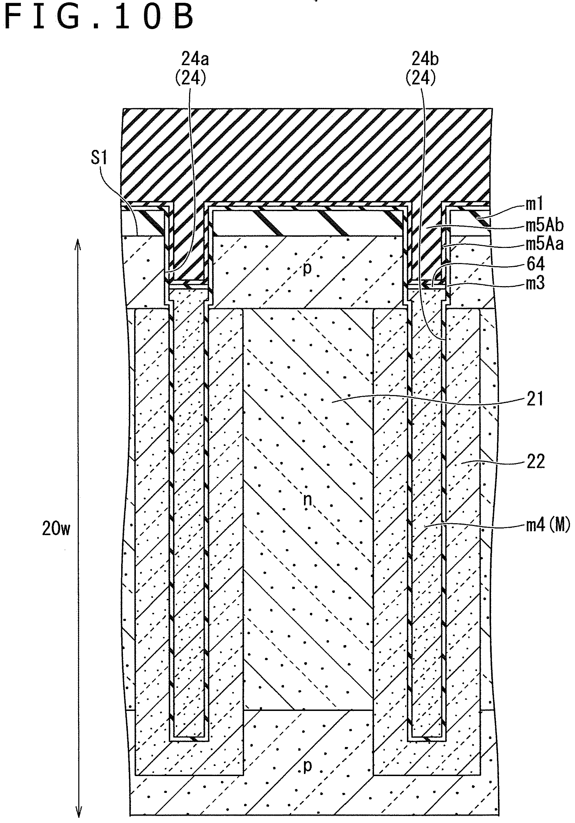

   FIG. 10B is a process sectional view continued from FIG. 10A.
[FIG. 10C]

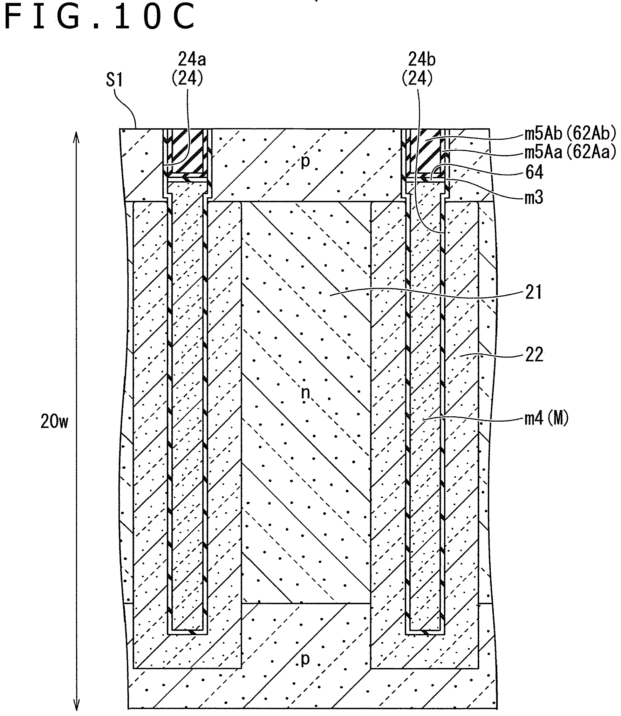

   FIG. 10C is a process sectional view continued from FIG. 10B.
[FIG. 11]

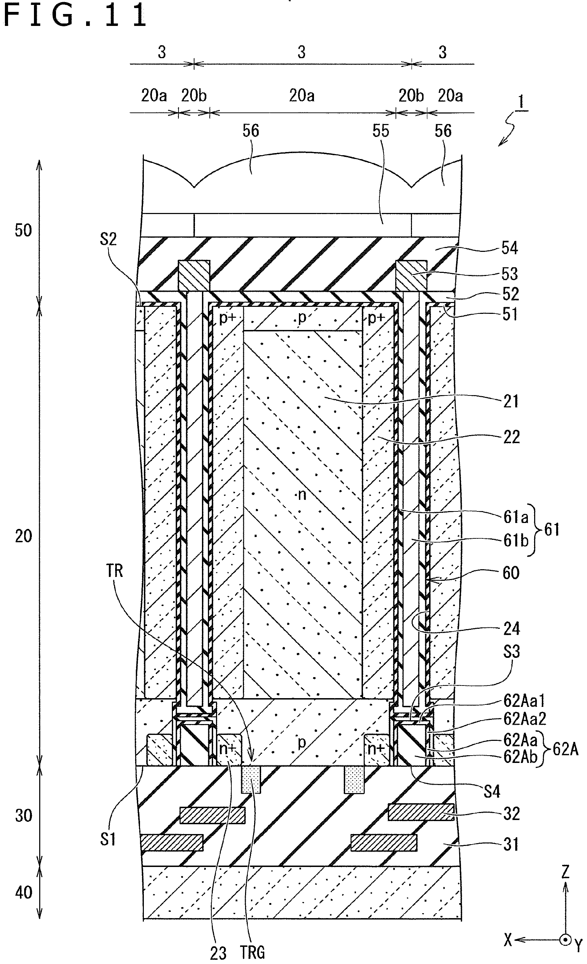

   FIG. 11 is a longitudinal sectional view depicting a cross-section structure of a pixel of a light detection device according to a modification example 2-1 of the second embodiment of the present technology.
[FIG. 12]

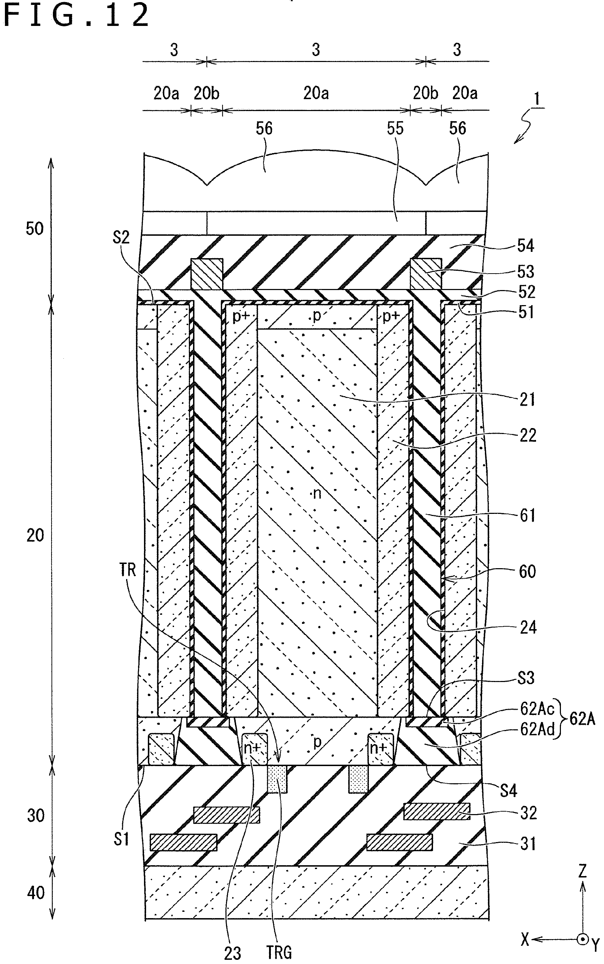

   FIG. 12 is a longitudinal sectional view depicting a cross-section structure of a pixel of a light detection device according to a modification example 2-3 of the second embodiment of the present technology.
[FIG. 13]

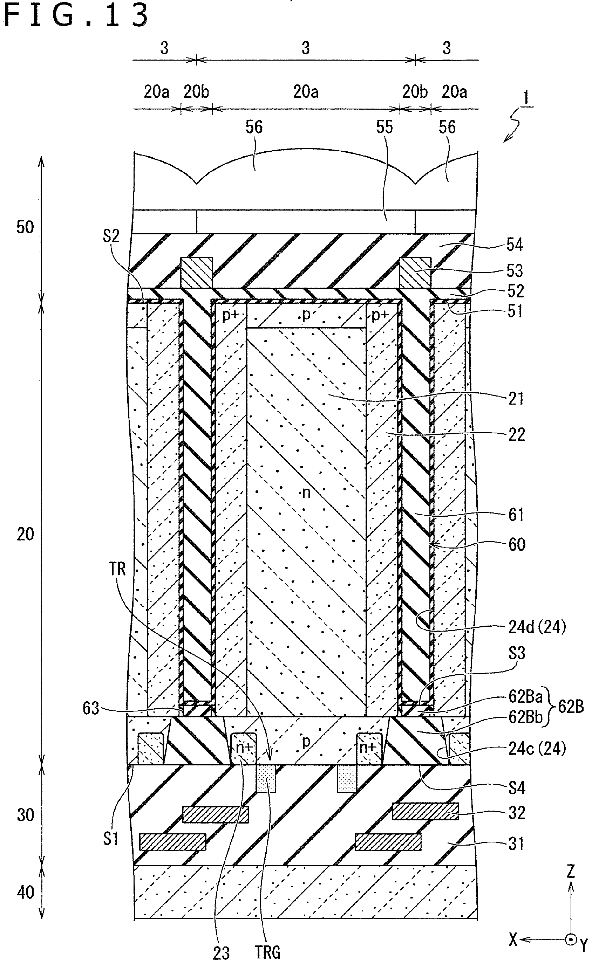

   FIG. 13 is a longitudinal sectional view depicting a cross-section structure of a pixel of a light detection device according to a third embodiment of the present technology.
[FIG. 14A]

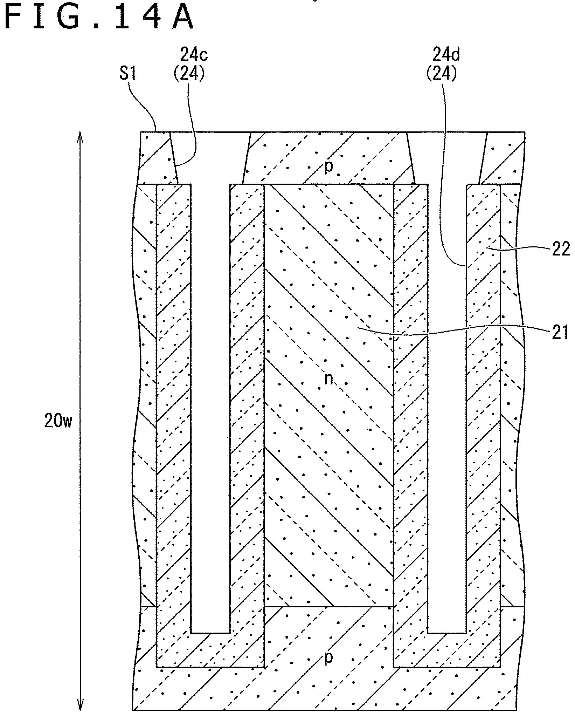

   FIG. 14A is a process sectional view schematically depicting a method of manufacturing the light detection device according to the third embodiment of the present technology.
[FIG. 14B]

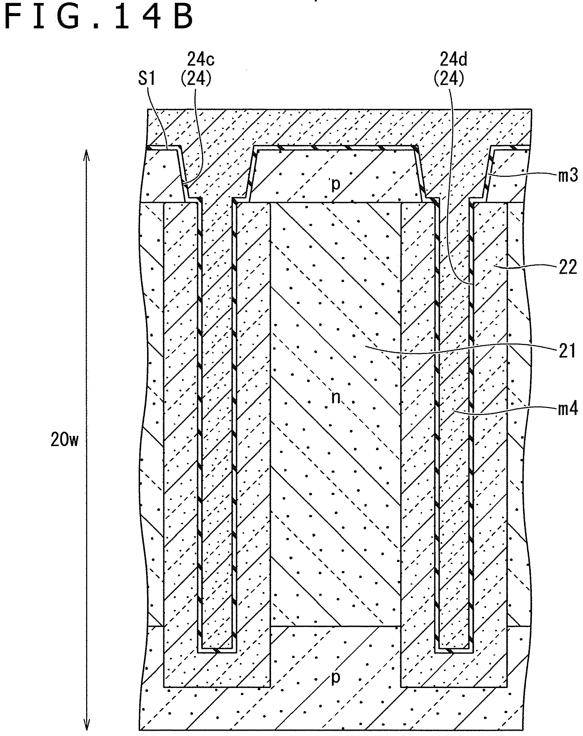

   FIG. 14B is a process sectional view continued from FIG. 14A.
[FIG. 14C]

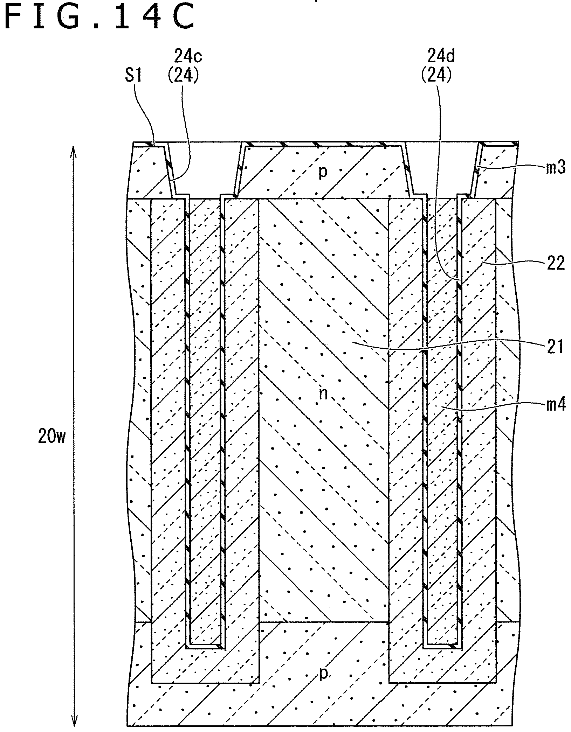

   FIG. 14C is a process sectional view continued from FIG. 14B.
[FIG. 14D]

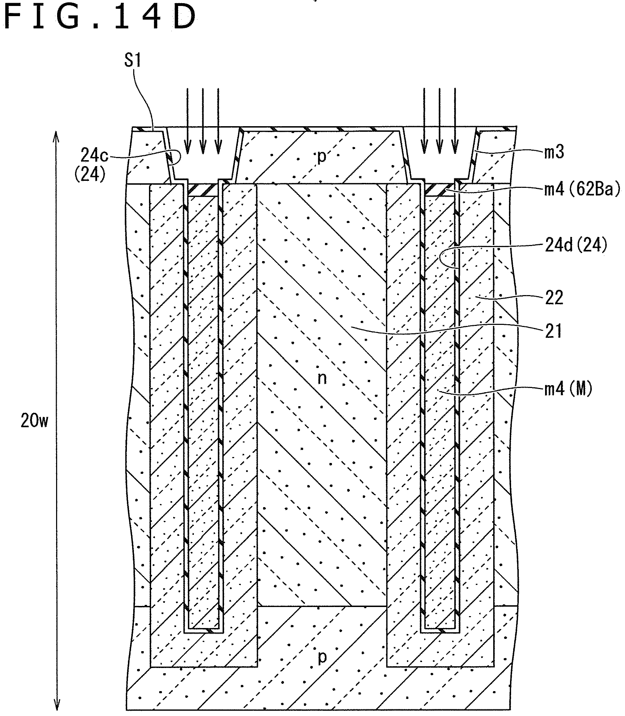

   FIG. 14D is a process sectional view continued from FIG. 14C.
[FIG. 14E]

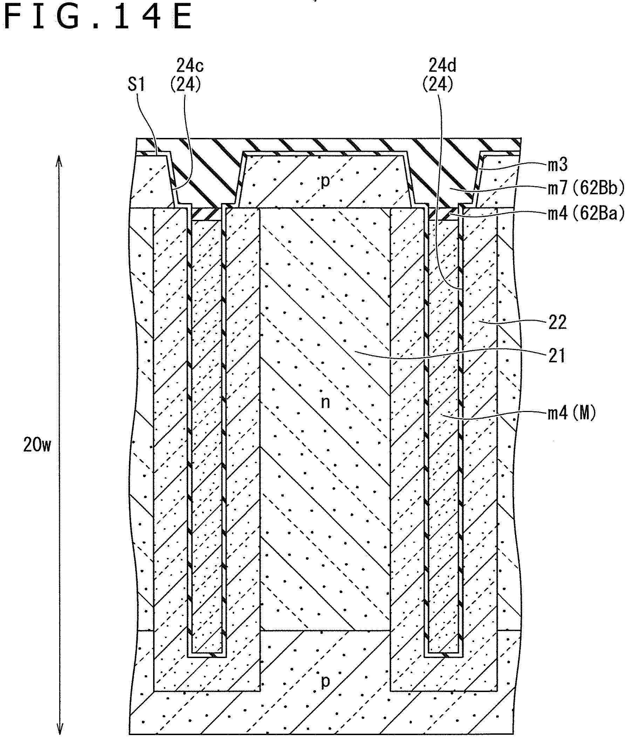

   FIG. 14E is a process sectional view continued from FIG. 14D.
[FIG. 14F]

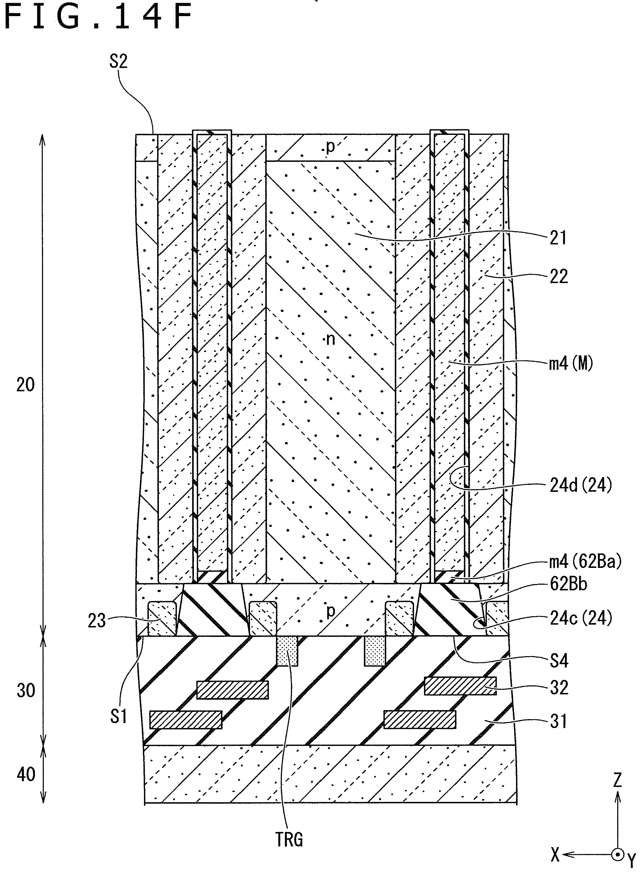

   FIG. 14F is a process sectional view continued from FIG. 14E.
[FIG. 14G]

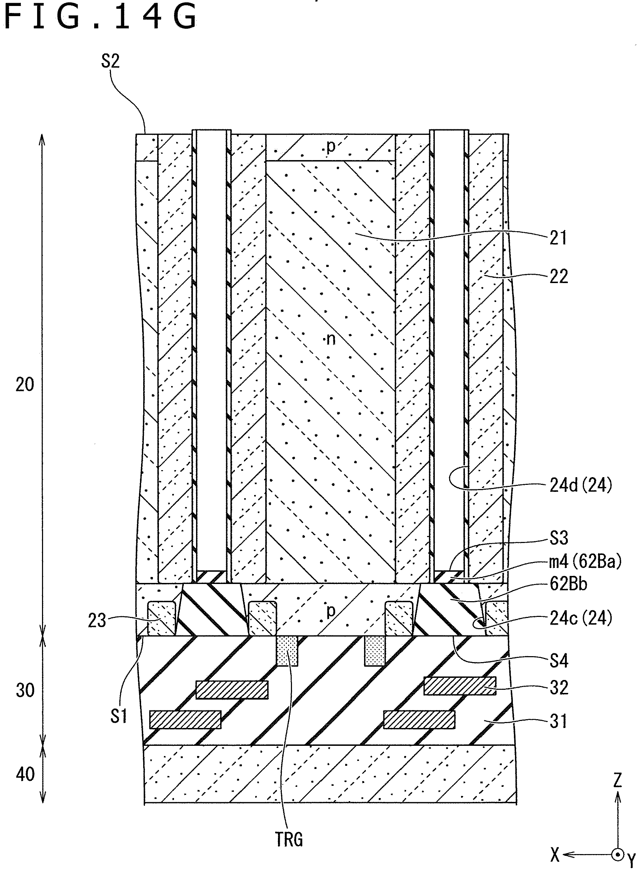

   FIG. 14G is a process sectional view continued from FIG. 14F.
[FIG. 15]

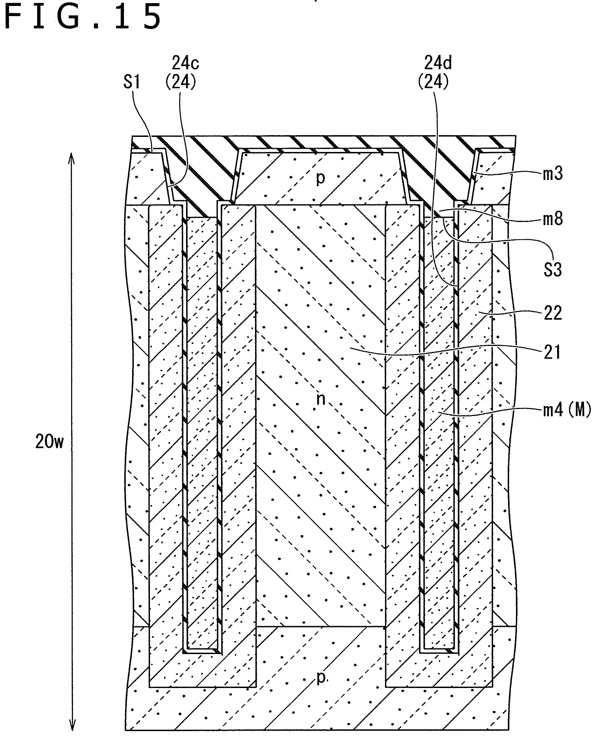

   FIG. 15 is a process sectional view schematically depicting a method of manufacturing a light detection device according to a modification example 3-2 of the third embodiment of the present technology.
[FIG. 16]

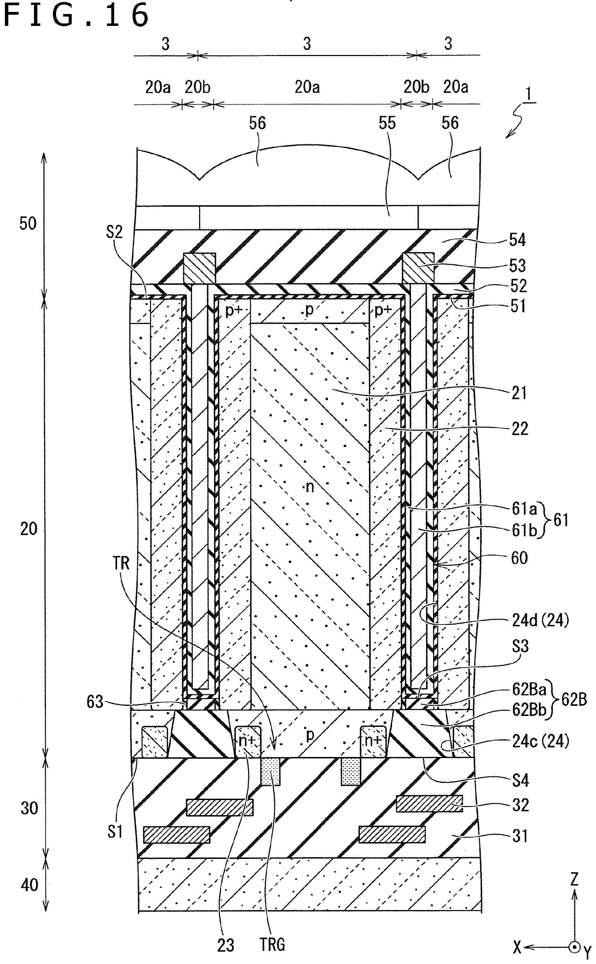

   FIG. 16 is a longitudinal sectional view depicting a cross-section structure of a pixel of a light detection device according to a modification example 3-3 of the third embodiment of the present technology.
[FIG. 17]

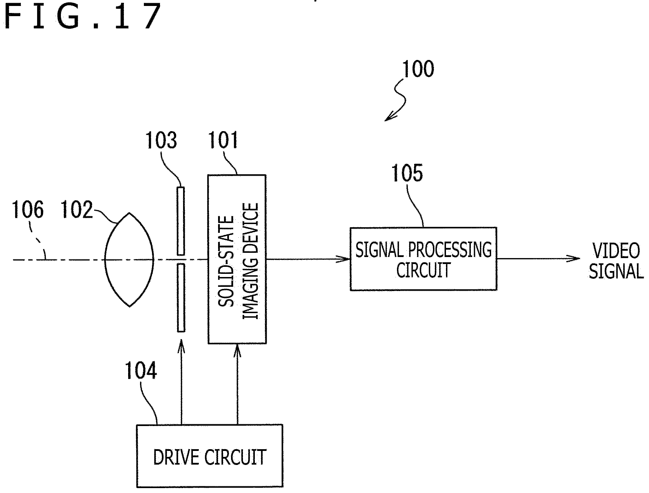

   FIG. 17 is a block diagram schematically depicting a configuration example of electronic equipment.
[FIG. 18]

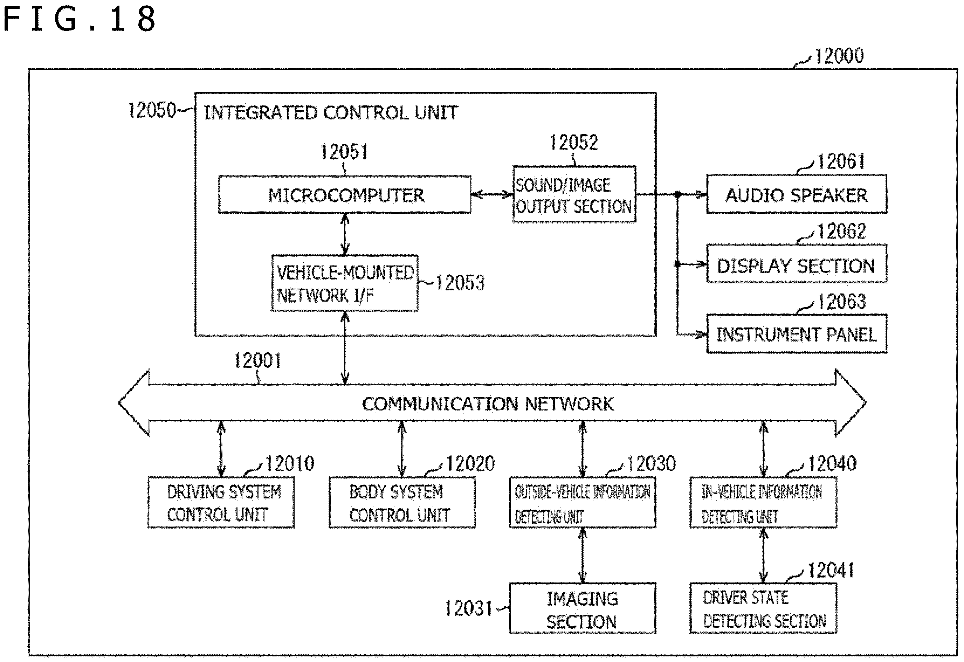

   FIG. 18 is a block diagram depicting an example of schematic configuration of a vehicle control system.
[FIG. 19]

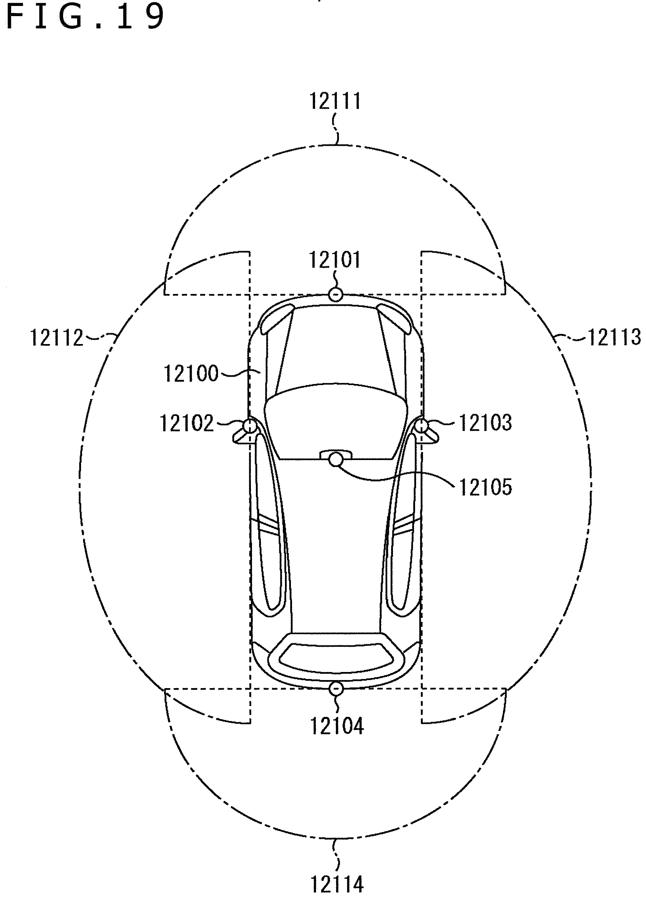

   FIG. 19 is a diagram of assistance in explaining an example of installation positions of an outside-vehicle information detecting section and an imaging section.
[FIG. 20]

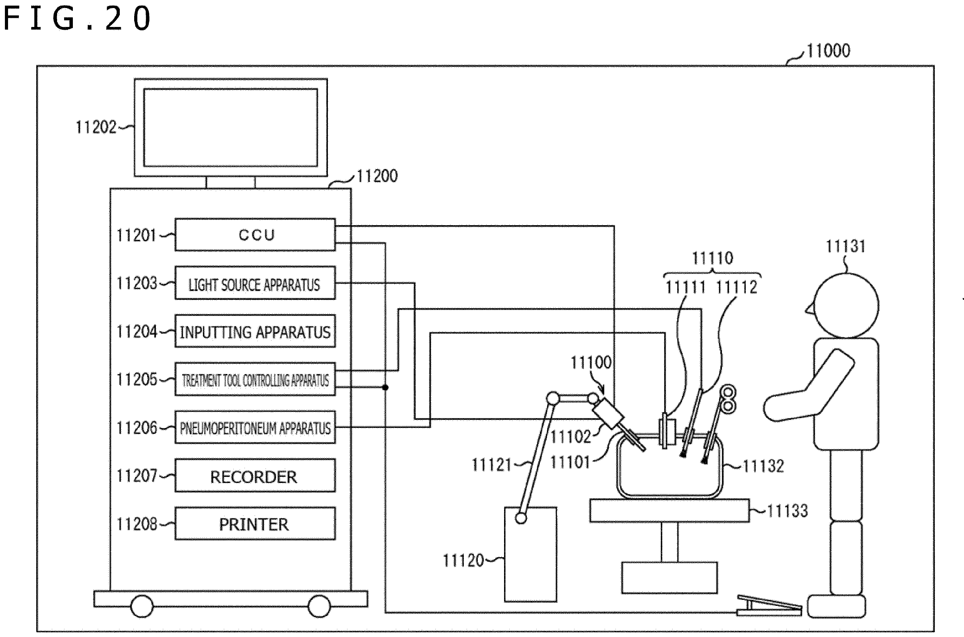

   FIG. 20 is a view depicting an example of a schematic configuration of an endoscopic surgery system.
[FIG. 21]

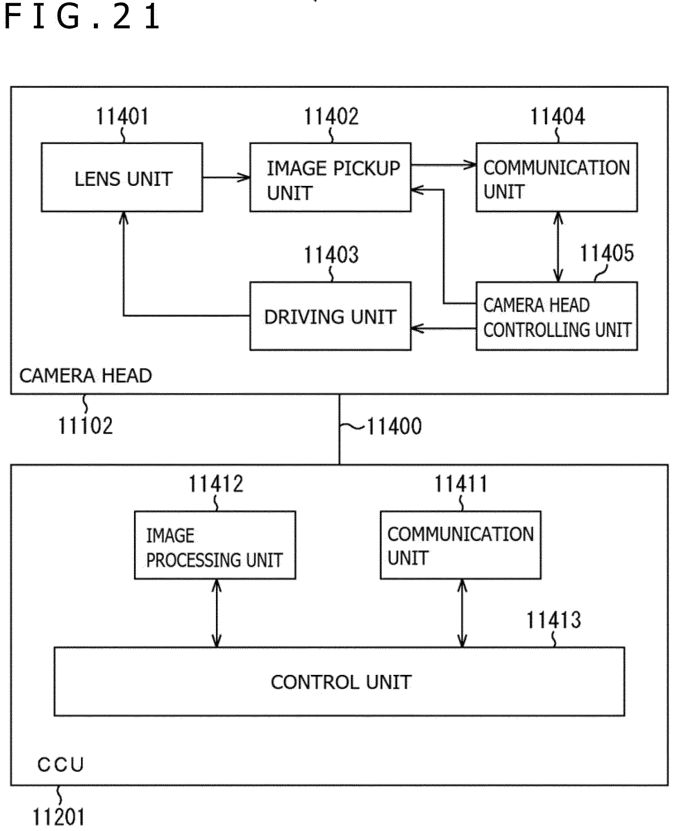

   FIG. 21 is a block diagram depicting an example of a functional configuration of a camera head and a camera control unit (CCU).

### [Description of Embodiments]

Some preferred embodiments of the present technology are described below with reference to the accompanying drawings. The embodiments explained hereunder are merely representative of how the present technology may be implemented, and should not be interpreted restrictively in accordance therewith.

Throughout the drawings, the same or similar parts are designated by the same or similar reference signs. It is to be noted that the drawings are only schematics and that the relation between thicknesses and planar dimensions, the proportions of different layers in terms of thickness, and the like may not coincide with what actually occurs. Specific thicknesses and dimensions should thus be determined in consideration of the ensuing description. Obviously, different drawings may include differences in size or proportion of the same parts.

The first through fourth embodiments to be discussed below are examples of methods and devices embodying the technical ideas of the present technology. As such, these embodiments are not limitative of the technical ideas of this technology in terms of the material, shape, structure, arrangement, or the like of constituent elements. The technical ideas of the present technology may be diversely modified within the technical scope thereof as defined by the appended claims.

The description will be made in the following order:
1. First embodiment
2. Second embodiment
3. Third embodiment
4. Fourth embodiment
   Example of application to electronic equipment
   Example of application to mobile bodies
   Example of application to an endoscopic surgery system
5. Other embodiments

### [First embodiment]

A first embodiment to be explained below is an example in which the present technology is applied to a light detection device forming a back-illuminated CMOS (Complementary Metal Oxide Semiconductor) image sensor (solid-state imaging device).

### <<Overall configuration of the light detection device>>

An overall configuration of a light detection device 1 is explained first. As depicted in FIG. 1, the light detection device 1 according to the first embodiment of the present technology is configured centering on a semiconductor chip 2 in a two-dimensional rectangular shape in planar view. That is, the light detection device 1 is mounted on the semiconductor chip 2. As depicted in FIG. 17, the light detection device 1 admits image light (incident light 106) from a subject via an optical system (optical lens) 102, converts the quantity of the incident light 106 formed as an image on an imaging plane into electrical signals in units of pixels, and outputs the converted electrical signals as pixel signals.

As depicted in FIG. 1, the semiconductor chip 2 carrying the light detection device 1 has a rectangular-shaped pixel region 2A in the middle of a two-dimensional plane including an X direction and a Y direction intersecting each other, and a peripheral region 2B external to and surrounding the pixel region 2A.

The pixel region 2A is a light-receiving plane that receives the light focused by the optical system 102 depicted in FIG. 17, for example. In the two-dimensional plane including the X and Y directions, a plurality of pixels 3 are arranged in a matrix pattern in the pixel region 2A. In other words, the pixels 3 are repeatedly arranged in each of the X and Y directions intersecting each other within the two-dimensional plane. In this embodiment, the X and Y directions are perpendicular to each other, for example. The direction perpendicular to both of the X and Y directions is a Z direction (thickness direction).

As depicted in FIG. 1, a plurality of bonding pads 14 are arranged in the peripheral region 2B. The plurality of bonding pads 14 are arranged along each of the four sides of the semiconductor chip 2 on the two-dimensional plane, for example. Each of the plurality of bonding pads 14 is an input/output terminal for use in electrically connecting the semiconductor chip 2 to an external device.

### <Logic circuit>

As depicted in FIG. 2, the semiconductor chip 2 has a logic circuit 13 that includes a vertical drive circuit 4, column signal processing circuits 5, a horizontal drive circuit 6, an output circuit 7, and a control circuit 8. The logic circuit 13 includes, for example, a CMOS (Complementary MOS) circuit having n-channel conductivity type MOSFETs (Metal Oxide Semiconductor Field Effect Transistors) and p-channel conductivity type MOSFETs as field effect transistors.

The vertical drive circuit 4 includes a shift register, for example. The vertical drive circuit 4 successively selects desired pixel drive lines 10, and supplies pulses to the selected pixel drive lines 10 for driving relevant pixels 3 so as to drive the pixels 3 in units of rows. That is, the vertical drive circuit 4 selectively scans the pixels 3 in the pixel region 2A in units of rows successively in a vertical direction. The vertical drive circuit 4 then supplies the column signal processing circuits 5 via vertical signal lines 11 with the pixel signals that come from the pixels 3 and that are based on signal charges generated by a photoelectric conversion element of each pixel 3 reflecting the quantity of received light.

The column signal processing circuits 5 are each arranged for each column of the pixels 3, for example. Given signals output from each row of the pixels 3, the column signal processing circuits 5 perform signal processing such as noise removal on the signals output from each pixel column. For example, the column signal processing circuits 5 carry out signal processing such as CDS (Correlated Double Sampling) for removal of fixed pattern noises specific to pixels and AD (Analog Digital) conversion. In an output stage of the column signal processing circuits 5, a horizontal selection switch (not depicted) is provided in such a manner as to be connected to a horizontal signal line 12.

The horizontal drive circuit 6 includes a shift register, for example. The horizontal drive circuit 6 successively selects each of the column signal processing circuits 5 by consecutively outputting horizontal scanning pulses to the column signal processing circuits 5. The horizontal drive circuit 6 then causes each of the column signal processing circuits 5 to output the pixel signal having undergone signal processing, onto the horizontal signal line 12.

Given the pixel signals supplied successively from each column signal processing circuit 5 via the horizontal signal line 12, the output circuit 7 performs signal processing on the supplied pixel signals and outputs the resultant signals. The signal processing may include, for example, buffering, black level adjustment, column variation correction, and various types of digital signal processing.

In accordance with a vertical synchronization signal, a horizontal synchronization signal, and a master clock signal, the control circuit 8 generates a clock signal and control signals providing reference to the operation of the vertical drive circuit 4, the column signal processing circuits 5, the horizontal drive circuit 6, and the like. The control circuit 8 then outputs the generated clock signal and control signals to the vertical drive circuit 4, the column signal processing circuits 5, the horizontal drive circuit 6, and the like.

### <Pixels>

FIG. 3 is an equivalent circuit diagram depicting a configuration example of a pixel 3. The pixel 3 has a photoelectric conversion element PD, a charge accumulation region (Floating Diffusion) FD that accumulates a signal charge resulting from photoelectric conversion by the photoelectric conversion element PD, and a transfer transistor TR that transfers the signal charge resulting from photoelectric conversion by the photoelectric conversion element PD to the charge accumulation region FD. The pixel 3 further includes a readout circuit 15 connected electrically to the charge accumulation region FD.

The photoelectric conversion element PD generates the signal charge reflecting the quantity of received light. Also, the photoelectric conversion element PD temporarily accumulates (holds) the generated signal charge. A cathode side of the photoelectric conversion element PD is electrically connected to a source region of the transfer transistor TR. An anode side of the photoelectric conversion element PD is electrically connected to a reference potential line (e.g., ground). For example, a photodiode may be used as the photoelectric conversion element PD.

A drain region of the transfer transistor TR is electrically connected to the charge accumulation region FD. A gate electrode of the transfer transistor TR is electrically connected to a transfer transistor drive line among the pixel drive lines 10 (see FIG. 2).

The charge accumulation region FD temporarily accumulates and holds the signal charge transferred from the photoelectric conversion element PD via the transfer transistor TR.

The readout circuit 15 reads the signal charge from the charge accumulation region FD so as to output a pixel signal based on the signal charge. The readout circuit 15 includes, but is not limited to, an amplification transistor AMP, a selection transistor SEL, and a reset transistor RST, for example, as pixel transistors. These transistors (AMP, SEL, RST) each include, for example, a MOSFET that has a gate insulating film including a silicon oxide film (SiO₂ film), a gate electrode, and a pair of main electrode regions acting as a source region and a drain region. These transistors may each alternatively include a MISFET (Metal Insulator Semiconductor FET) of which the gate insulating film is a silicon nitride film (Si₃N₄ film) or is a multilayer film including a silicon nitride film, a silicon oxide film, and the like.

A source region of the amplification transistor AMP is electrically connected to a drain region of the selection transistor SEL. A drain region of the amplification transistor AMP is electrically connected to a power supply line Vdd and to a drain region of the reset transistor. A gate electrode of the amplification transistor AMP is electrically connected to the charge accumulation region FD and to a source region of the reset transistor RST.

A source region of the selection transistor SEL is electrically connected to a vertical signal line 11 (VSL). The drain of the selection transistor SEL is electrically connected to the source region of the amplification transistor AMP. A gate electrode of the selection transistor SEL is electrically connected to a selection transistor drive line among the pixel drive lines 10 (see FIG. 2).

The source region of the reset transistor RST is electrically connected to the charge accumulation region FD and to the gate electrode of the amplification transistor AMP. The drain region of the reset transistor RST is electrically connected to the power supply line Vdd and to the drain region of the amplification transistor AMP. A gate electrode of the reset transistor RST is electrically connected to a reset transistor drive line among the pixel drive lines 10 (see FIG. 2).

### <<Specific configuration of the light detection device>>

A specific configuration of the light detection device 1 is explained next with reference to FIG. 4.

### <Multilayer structure of the light detection device>

As depicted in FIG. 4, the light detection device 1 (semiconductor chip 2) has a multilayer structure in which a light collecting layer 50, a semiconductor layer 20, a wiring layer 30, and a support substrate 40 such as a semiconductor substrate are stacked in this order.

### <Semiconductor layer>

The semiconductor layer 20 includes a semiconductor substrate. The semiconductor layer 20 includes, but is not limited to, a monocrystal silicon substrate, for example. The semiconductor layer 20 has an element forming surface S1 (the other surface) and a light incident surface S2 (one surface) positioned opposite to each other. Here, the element forming surface S1 of the semiconductor layer 20 may be referred to as the principal surface and the light incident surface S2 of the semiconductor layer 20 as the back side. Further, the element forming surface S1 is on the side of the wiring layer 30, and the light incident surface S2 is on the side of the light collecting layer 50.

The semiconductor layer 20 has a photoelectric conversion region 20a formed in each pixel 3. More specifically, in the semiconductor layer 20, island-shaped photoelectric conversion regions 20a partitioned by separation regions 20b are provided in the respective pixels 3, for example. The photoelectric conversion regions 20a each include a first region 21, a second region 22, a charge accumulation region 23, a well region, and the like. The first region 21 is a first conductivity type semiconductor region such as an n-type semiconductor region (photoelectric conversion part). The second region 22 is a second conductivity type semiconductor region such as a p-type semiconductor region. The charge accumulation region 23 is a first conductivity type semiconductor region such as an n-type semiconductor region that constitutes the charge accumulation region FD depicted in FIG. 3. The well region is a second conductivity type semiconductor region such as a p-type semiconductor region. The photoelectric conversion element PD in FIG. 3 is formed in the photoelectric conversion region 20a. The photoelectric conversion region 20a performs photoelectric conversion on the incident light to generate the signal charge.

Also formed in the semiconductor layer 20 are elements such as the transistors constituting the logic circuit 13 depicted in FIG. 2 and elements such as the transistors in FIG. 3. The example in FIG. 4 indicates the transfer transistor TR formed in the photoelectric conversion region 20a. The transfer transistor TR transfers the signal charge generated by photoelectric conversion to the charge accumulation region 23. The charge accumulation region 23 accumulates the signal charge.

The separation regions 20b have a trench structure in which trenches 24 are formed in the semiconductor layer 20 and filled with separation parts 60 or the like, to be discussed later. The trenches 24 are positioned in a manner partitioning the photoelectric conversion regions 20a in planar view in the semiconductor layer 20. As depicted in FIG. 4, the trenches 24 are formed in the separation regions 20b of the semiconductor layer 20, for example. Also, the trenches 24 penetrate the semiconductor layer 20 in the thickness direction thereof. That is, the trenches 24 are formed to provide FTI (Full Trench Isolation).

### <Light collecting layer>

The light collecting layer 50 includes, but is not limited to, for example, a fixed charge film 51, an insulating film 52, a light blocking layer 53, a planarizing film 54, a color filter 55, and a micro lens (on-chip lens) 56 stacked in this order from the side of the light incident surface S2.

### (Fixed charge film)

The fixed charge film 51 is deposited on the semiconductor layer 20 on the side of the light incident surface S2. More specifically, the fixed charge film 51 is deposited in regions including the light incident surface S2 and inner walls of the trenches 24, in a manner covering a surface of the semiconductor layer 20. The fixed charge film 51 is also formed between a first separation part 61 and a second separation part 62, to be discussed later. That is, the fixed charge film 51 is formed at least between the first and second separation parts 61 and 62 to be described below. When the trenches 24 are formed in the semiconductor layer 20, the processed surface of the semiconductor layer 20 develops defects. The fixed charge film 51 has a function of capturing electrons and holes that may be generated from the semiconductor layer 20 having defects. For example, the fixed charge film 51 includes hafnium oxide (HfO₂). Alternatively, zirconium dioxide (ZrO₂), tantalum oxide (Ta₂O₅), or the like may be used to form the fixed charge film 51.

### (Insulating film)

The insulating film 52 is deposited by the CVD method, for example, on that surface of the fixed charge film 51 that is opposite to its surface on the side of the semiconductor layer 20. The insulating film 52 is a silicon oxide (SiOz) film, for example. The insulating film 52 is deposited in a manner planarizing the trenches 24 by filling them. The insulating film 52 deposited in the trenches 24 via the fixed charge film 51 constitutes the first separation part 61, to be discussed below.

### (Light blocking layer)

The light blocking layer 53 is stacked on that surface of the insulating film 52 that is opposite to its surface on the side of the fixed charge film 51. More specifically, the light blocking layer 53 is overlaid on the separation regions 20b in planar view. Any suitable light blocking material can be used to form the light blocking layer 53. For example, tungsten (W), aluminum (Al), copper (Cu), or the like can be used.

### (Planarizing film)

The planarizing film 54 is formed in a manner covering that surface of the insulating film 52 that is opposite to its surface on the side of the fixed charge film 51 as well as the light blocking layer 53. Silicon oxide can be used as the material to form the planarizing film 54, for example.

### (Color filter and micro lens)

The micro lens 56 focuses the incident light on the semiconductor layer 20. The color filter 55 separates by color the incident light on the semiconductor layer 20. The color filter 55 and the micro lens 56 are formed in each of the pixels 3. The color filter 55 and the micro lens 56 each include a resinous material, for example.

### <Separation parts>

The separation parts 60 are formed in the trenches 24 to partition the photoelectric conversion regions 20a. The separation parts 60 each include, in the thickness direction of the light detection device 1, the first separation part 61 positioned closer to the side of the light incident surface S2 and the second separation part 62 positioned closer to the side of the element forming surface S1. Of the first and second separation parts 61 and 62, the first separation part 61 is used primarily to partition the photoelectric conversion regions 20a. The size of the first separation part 61 in the thickness direction of the semiconductor layer 20 is greater than that of the second separation part 62. Of the first and second separation parts 61 and 62, the second separation part 62 is used not only to partition the photoelectric conversion regions 20a but also to function as a cap on the separation part 60. With the first separation part 61 serving as a cap, the FTI's shape deformation under the influence of various processes as the transistors, contacts, wires, and the like are being formed on the side of the element forming surface S1 can be suppressed. The first separation part 61 is constituted primarily by that portion of the insulating film 52 that is deposited in the trench 24. The first separation part 61 includes silicon oxide, for example. The second separation part 62 has a first surface S3 on the side of the first separation part 61 and a second surface S4 opposite to the first surface S3. The second surface S4 of the second separation part 62 faces the element forming surface S1.

The first surface S3 is faced with a first material that suppresses etching of the second separation part 62. The first surface S3 thus functions as an etching stop surface. More specifically, the second separation part 62 includes the first material. For example, among materials for a semiconductor device, the first material is a material resistant to an alkaline etchant such as hydrogen fluoride. Materials of this type include silicon nitride (Si₃N₄), titanium nitride (TiN), and tungsten (W), for example. This embodiment is explained on the assumption that the first material is silicon nitride. It is to be noted that the first material may include impurities.

A distance "a" between the first surface S3 of the second separation part 62 and the element forming surface S1 is from 200 nm to 300 nm inclusive. The distance "a" is greater than a size "b" of the charge accumulation region 23 in the thickness direction. For example, in a case where the distance "a" is 200 nm and the size "b" is 100 nm, the distance between the first surface S3 and the charge accumulation region 23 in the thickness direction is 100 nm. Therefore, there also is a distance of 100 nm between the charge accumulation region 23 on one hand, and the portion of the fixed charge film 51 closest to the element forming surface S1, i.e., the portion between the first surface S3 and the first separation part 61 on the other hand. In this manner, making the distance "a" greater than the size "b" can prevent the fixed charge film 51 and the charge accumulation region 23 from approaching each other. This makes it possible to suppress noise between the fixed charge film 51 and the charge accumulation region 23, thereby preventing electrical shorts. Including the first material, the second separation part 62 also measures between 200 nm and 300 nm inclusive in the thickness direction of the semiconductor layer 20.

An insulating film 63 covers a side surface (perpendicular to the Z direction) of the second separation part 62. The insulating film 63 includes silicon oxide, for example.

### <Wiring layer>

The wiring layer 30 includes an insulating film 31, wiring 32, a gate electrode TRG of the transfer transistor TR, and vias and contacts not depicted. The wiring 32 is stacked via the insulating film 31 as illustrated. The wiring 32 includes, but not limited to, metal such as copper or aluminum.

### <<Method of manufacturing the light detection device>>

A method of manufacturing the light detection device 1 is explained below with reference to FIGS. 5A through 5N. It is to be noted that what is described below are primarily the processes of forming the separation parts 60. For this reason, those constituent elements of the light detection device 1 which can be formed by known methods may be omitted from the explanation of the forming processes. First, as depicted in FIG. 5A, a film m1 having openings m1a is formed as a hard mask on the element forming surface S1 of a semiconductor layer 20w. The openings m1a are positioned in a manner partitioning the photoelectric conversion regions 20a. Thereafter, a known etching technique is used to etch the semiconductor layer 20w from the openings m1a to form trenches 24a. The semiconductor layer 20w is thus formed with the trenches 24a in the positions for partitioning the photoelectric conversion regions 20a from the side of the element forming surface S1. The film m1 may have a multilayer structure in which a plurality of types of insulating films including silicon oxide and silicon nitride, for example, are stacked. The trenches 24a have a depth "c" in the depth direction of the semiconductor layer 20w from the element forming surface S1. The region of the semiconductor layer 20w from the element forming surface S1 to the depth "c" is a region where the second region 22 depicted in FIG. 4 is not formed.

Next, as depicted in FIG. 5B, a liner film m2 for protecting side walls of the trenches 24a is stacked on exposed surfaces of the semiconductor layer 20w and the film m1. The liner film m2 may have a multilayer structure in which a plurality of types of insulating films including silicon oxide and silicon nitride, for example, are stacked. Thereafter, as depicted in FIG. 5C, a known etching technique is used to form trenches 24b extending from a bottom of the trenches 24a in the thickness direction of the semiconductor layer 20w. The second region 22 is then formed by injecting impurities into exposed surfaces including side walls and a bottom of the trenches 24b. At this point, the side walls of the trenches 24a are protected by the liner film m2 and thus impervious to the impurities being injected. Thereafter, the liner film m2 is removed. The film m1, which is the hard mask, is also partially removed to be made thinner. It is to be noted that, in a case where there is no need to distinguish the trenches 24a and 24b from each other, these trenches are simply referred to as the trenches 24.

Next, as depicted in FIG. 5D, a film m3 as a silicon oxide film is stacked in a manner covering the exposed surfaces including the side walls and the bottom of the trenches 24. A film m4 constituting a sacrificial layer is further stacked. More specifically, the film m4 is stacked in a manner filling the trenches 24. The film m4 includes, but is not limited to, a polysilicon (Poly-Si) film, for example. Thereafter, as depicted in FIG. 5E, a known etch-back technique is used to remove excess portions of the film m4. The portions of the film m4 ranging from the element forming surface S1 to the distance "a" in the thickness direction are removed. Of the film m4 filling the trenches 24a, the portions ranging from the element forming surface S1 to the distance "a" in the thickness direction are thus removed. Further, in the description that follows, the film m4 left intact in the trenches 24 may be referred to as the sacrificial layer M.

Then, as depicted in FIG. 5F, a film m5 including the first material is stacked inside the trenches 24a. The first material is a material of which the etching rate relative to the selected etchant is lower than that of the material constituting the sacrificial layer M (polysilicon in this embodiment). Examples of such a material include silicon nitride (Si₃N₄), titanium nitride (TiN), and tungsten (W). This embodiment is explained on the assumption that the first material is silicon nitride. As a result, in the trenches 24 (trenches 24a), the sacrificial layer M and the film m5 including the first material are stacked in this order in the thickness direction of the semiconductor layer 20w. Thereafter, as depicted in FIG. 5G, a known etch-back technique, a CMP (Chemical Mechanical Polishing) method, or the like may be used, for example, to planarize the exposed surfaces by removing excess portions of the first material and the film m1 serving as the hard mask. This leaves intact those portions of the film m5 which are embedded in the trenches 24a. More specifically, of the film m5, those portions ranging from the element forming surface S1 to the distance "a" in the thickness direction are left intact. The remaining portions make up the second separation part 62.

Thereafter, as depicted in FIG. 5H, a gate electrode TRG is formed on the element forming surface S1. A charge accumulation region 23 is formed in the semiconductor layer 20w by doping with impurities. More specifically, the charge accumulation region 23 is formed by getting the region from the element forming surface S1 to the depth "b" (size "b") in the thickness direction targeted for doping with impurities. Then, as depicted in FIG. 5I, the wiring layer 30 is formed on the element forming surface S1. The support substrate 40 is further bonded to the wiring layer 30.

Next, as depicted in FIG. 5J, the semiconductor layer 20w on which the wiring layer 30 and the support substrate 40 are formed is turned upside down. The CMP method, for example, is used to grind that surface of the semiconductor layer 20w that is opposite to the side of the element forming surface S1 so as to make the semiconductor layer 20w thinner. This leaves intact the portions corresponding to the semiconductor layer 20. This also exposes the sacrificial layer M from the side of the light incident surface S2 opposite to the element forming surface S1.

Then, as depicted in FIG. 5K, a film m6 having openings m6a is formed as a hard mask on the light incident surface S2 of the semiconductor layer 20. The openings m6a are positioned to overlap with the sacrificial layer M embedded in the trenches 24 in planar view. Thereafter, as depicted in FIG. 5L, a known etching technique is used to etch the sacrificial layer M via the openings m6a. This removes the sacrificial layer M embedded in the trenches 24. At this point, of the surfaces of the second separation part 62, the first surface S3 closer to the first separation part 61 functions as an etching stop surface. More specifically, the first material constituting the second separation part 62 and its first surface S3 is a material of which the etching rate relative to the selected etchant is lower than that of the material forming the sacrificial layer M (polysilicon in this embodiment). For this reason, the first surface S3 is hardly or not at all etched. As a result, solely the sacrificial layer M can be removed while the second separation part 62 including the first material is left intact. It is to be noted that, for example, hydrogen fluoride can be used as the etchant but is not limitative. The film m6 serving as the hard mask may include silicon oxide, for example. Thereafter, the film m6 as the hard mask is removed.

Next, as depicted in FIG. 5M, excess portions of the film m3, which is a silicon oxide film, are removed. More specifically, of the film m3, the portions except for those covering the side surface (perpendicular to the Z direction) of the second separation part 62 are removed. This can leave intact those portions of the film m3 corresponding to the insulating film 63.

Thereafter, as depicted in FIG. 5N, the fixed charge film 51 and the insulating film 52 are stacked in this order on the exposed surfaces including the side walls of the trenches 24, the first surface S3 of the second separation part 62, and the light incident surface S2. Those portions of the insulating film 52 deposited in the trenches 24 via the fixed charge film 51 constitute the first separation part 61. This is how the first separation part 61 is formed. Thereafter, the remaining portions of the light collecting layer 50 are formed, which substantially completes the light detection device 1 depicted in FIG. 4. Further, the light detection device 1 is formed in each of a plurality of chip forming regions partitioned by scribe lines (dicing lines) on the semiconductor substrate. Dividing the plurality of chip forming regions along the scribe lines forms semiconductor chips 2 each carrying the light detection device 1.

### <<Major advantageous effects of the first embodiments

Prior to an explanation of major advantageous effects of the first embodiment, an existing configuration is briefly described below. In the existing configuration, the first surface S3 of the second separation part 62 does not have the function of suppressing etching of the second separation part 62. There is thus a possibility that, upon removal of the sacrificial layer M, the second separation part 62 may be etched significantly. With the second separation part 62 etched, those portions of the subsequently formed fixed charge film 51 that are closer to the wiring layer 30 may be positioned closer to the charge accumulation region 23 than in design. In this case, the distance between the fixed charge film 51 and the charge accumulation region 23 may become shorter than in design, possibly generating an intense electric field therebetween. This may lead to the worsening of white spots and of dark current characteristics. There also is a possibility that an electrical short-circuit may occur between the fixed charge film 51 and the charge accumulation region 23.

In the light detection device 1 according to the first embodiment of the present technology, by contrast, the first surface S3 of the second separation part 62 closer to the first separation part 61 is faced with the first material that suppresses etching of the second separation part 62. This makes it possible to suppress etching of the second separation part 62 upon removal of the sacrificial layer M. That in turn makes it possible to prevent the distance between the fixed charge film 51 and the charge accumulation region 23 from becoming shorter than in design. As a result, the occurrence of an intense electric field can be suppressed between the fixed charge film 51 and the charge accumulation region 23. Without the intense electric field between the fixed charge film 51 and the charge accumulation region 23, the worsening of white spots and of dark current characteristics can be prevented. With no contact between the fixed charge film 51 and the charge accumulation region 23, an electrical short-circuit therebetween can be prevented. In this manner, it is possible to suppress the worsening of noise characteristics.

Also, in the light detection device 1 according to the first embodiment of the present technology, the etching of the second separation part 62 is suppressed upon removal of the sacrificial layer M. It is further possible to control the size of the second separation part 62 in the thickness direction. As a result, the distance "a" between the first surface S3 of the second separation part 62 and the element forming surface S1 can be prevented from getting varied under the influence of the process of removing the sacrificial layer M. That in turn makes it possible to suppress the worsening of PD (Photo Diode) white spots caused by a prolonged distance "a" and deterioration of FD (Floating Diffusion) white spots caused by a shortened distance "a." In this manner, the worsening of noise characteristics can be suppressed.

Further, in the light detection device 1 according to the first embodiment of the present technology, the separation parts 60 including the first separation part 61 and the second separation part 62 formed in the trenches 24 provide the FTI. In other words, the separation parts 60 on the side of the element forming surface S1 do not constitute an STI (Shallow Trench Isolation) structure. As a result, the separation parts 60 save space and can be prevented from getting larger in planar view. This can suppress reduction in the degree of freedom in designing the side of the element forming surface S1 even in a case where the photoelectric conversion region 20a is reduced in size by miniaturization.

Also, in the light detection device 1 according to the first embodiment of the present technology, the trenches 24 are formed starting from the side of the element forming surface S1. This can improve the overlay accuracy between the trenches 24 and the wiring layer 30 as well as the overlay accuracy between the trenches 24 and the other constituent elements in the semiconductor layer 20 (e.g., charge accumulation region 23). Furthermore, following formation of the wiring layer 30, the material (silicon oxide) constituting the first separation part 61 is embedded into the trenches 24 from the side of the light incident surface S2. Consequently, the material making up the first separation part 61 is not subjected to heat treatment at the time the wiring layer 30 is formed. As a result, warpage and cracking of a wafer can be prevented.

### <<Modification examples of the first embodiments

### <Modification example 1-1>

In the first embodiment of the present technology, the first separation part 61 includes silicon oxide. However, this is not limitative of the present technology. As depicted in FIG. 6, the first separation part 61 may alternatively have a multilayer structure in which a portion 61a including silicon oxide and a portion 61b including metal are stacked in this order, or may have metal alone. The metal constituting the portion 61b may be, but is not limited to, aluminum or tungsten, for example.

The light detection device 1 according to the modification example 1-1 provides advantageous effects similar to those of the light detection device 1 according to the first embodiment discussed above.

Further, in the light detection device 1 according to the modification example 1-1, the first separation part 61 includes the portion 61b including metal. This further suppresses color mixing between the photoelectric conversion regions 20a. Moreover, in the case where the first separation part 61 includes metal, the first material of the second separation part provides an advantageous effect of preventing diffusion of the metal.

### <Modification example 1-2>

In the first embodiment of the present technology, the entire second separation part 62 includes the first material. However, this is not limitative of the present technology. As depicted in FIG. 7, the second separation part 62 may alternatively have a multilayer structure in which a first layer 62a including the first material and forming the first surface S3 and a second layer 62b including a second material different from the first material are stacked. It is to be noted that the second material may include impurities. In this modification example 1-2, the second material is an insulating material such as silicon oxide. The thickness of the first layer 62a in the thickness direction of the semiconductor layer 20 may be between 50 nm and 200 nm inclusive, or between 50 nm and 100 nm inclusive, for example.

The light detection device 1 according to the modification example 1-2 also provides advantageous effects similar to those of the light detection device 1 according to the first embodiment discussed above.

In the light detection device 1 according to the modification example 1-2, the first layer 62a including silicon nitride and the second layer 62b including silicon oxide are stacked. This prevents the positive fixed charge of silicon nitride from affecting the semiconductor layer 20.

### <Modification example 1-3>

A modification example 1-3 of the first embodiment of the present technology is a combination of the above-described modification examples 1-1 and 1-2. As depicted in FIG. 8, the first separation part 61 has the portion 61a and the portion 61b, and the second separation part 62 has the first layer 62a and the second layer 62b.

The light detection device 1 according to the modification example 1-3 also provides advantageous effects similar to those of the light detection device 1 according to the first embodiment, the modification example 1-1, and the modification example 1-2 discussed above.

### <Modification example 1-4>

In the above-described modification example 1-2, the second material constituting the second layer 62b depicted in FIG. 7 is an insulating material. However, this is not limitative of the present technology. The second material making up the second layer 62b in FIG. 7 may alternatively be a conductive material such as polysilicon or tungsten.

The light detection device 1 according to the modification example 1-4 also provides advantageous effects similar to those of the light detection device 1 according to the first embodiment discussed above.

Since the second layer 62b includes the conductive material, the second separation part 62 can be used as an electrode. This improves the degree of freedom in design.

### <Modification example 1-5>

In the above-described modification example 1-3, the second material constituting the second layer 62b depicted in FIG. 8 is an insulating material. However, this is not limitative of the present technology. The second material forming the second layer 62b in FIG. 8 may alternatively be a conductive material such as polysilicon, for example.

The light detection device 1 according to the modification example 1-5 also provides advantageous effects similar to those of the light detection device 1 according to the first embodiment discussed above.

Since the second layer 62b includes the conductive material, the second separation part 62 may be used as an electrode. This improves the degree of freedom in design.

### [Second embodiment]

A second embodiment of the present technology depicted in FIG. 9A is explained below. The light detection device 1 according to the second embodiment differs from the light detection device 1 according to the first embodiment above in that a second separation part 62A is provided in place of the second separation part 62. The remaining configuration of the light detection device 1 is basically similar to the configuration of the light detection device 1 according to the first embodiment discussed above. The constituent elements explained already are designated by the same reference signs and will not be discussed further.

### <Separation parts>

The separation parts 60 each include the first separation part 61 positioned closer to the side of the light incident surface S2 and the second separation part 62A positioned closer to the side of the element forming surface S1 in the thickness direction of the light detection device 1.

The second separation part 62A has a multilayer structure in which a first layer 62Aa including the first material and constituting the first surface S3 and a second layer 62Ab including the second material different from the first material are stacked. Also, the separation parts 60 each have an insulating film 64 that separates the second separation part 62A and the first separation part 61 from each other or, to be more specific, separates the second separation part 62A and the fixed charge film 51 from each other. The first layer 62Aa has, more specifically, a facing part 62Aa1 and a side wall part 62Aa2, the facing part 62Aa1 facing the first separation part 61 and constituting the first surface S3, the side wall part 62Aa2 being positioned between the semiconductor layer 20 and the insulating film 64 (between a side surface of the second layer 62Ab and the insulating film 63). In this embodiment, the second material constituting the second layer 62Ab is an insulating material such as silicon oxide. The second separation part 62A has the first surface S3 closer to the first separation part 61 and the second surface S4 opposite to the side of the first surface S3. The first surface S3 functions as an etching stop surface. The second surface S4 of the second separation part 62A faces the element forming surface S1.

The first material may be, but is not limited to, silicon nitride, for example. Further, the first material is a material of which the etching rate relative to the selected etchant is lower than that of the material constituting the sacrificial layer M explained above in connection with the manufacturing method. For this reason, the first material need only be determined according to the material making up the sacrificial layer M. The first material may thus be something other than silicon nitride. For example, any one of polysilicon, silicon oxide, hafnium oxide (HfO₂), and aluminum oxide (Al₂O₃) may be selected as the first material, according to the material constituting the sacrificial layer M. For example, the thickness of the facing part 62Aa1 in the thickness direction of the semiconductor layer 20 (the thickness of the first layer 62Aa in the stacking direction) is between 5 nm and 50 nm inclusive or between 10 nm and 50 nm inclusive.

The insulating film 64 is provided to suppress the influence of the positive fixed charge borne by silicon nitride. The insulating film 64 is a silicon oxide film, for example. The insulating film 64 has a thickness between 10 nm and 20 nm inclusive, for example, but is not limited thereto. There may be cases where the influence of the positive fixed charge borne by silicon nitride can be suppressed depending on design, without recourse to the insulating film 64, as depicted in FIG. 9B. Further, the insulating film 64 may be given a thickness of 40 nm or less at the time of manufacture in consideration of etchant penetration from the side of the light incident surface S2.

### <<Method of manufacturing the light detection device>>

A method of manufacturing the light detection device 1 is explained below with reference to FIGS. 10A through 10C. It is to be noted that what is described below are primarily the processes of forming the separation parts 60. For this reason, those constituent elements of the light detection device 1 which can be formed by known methods may be omitted from the explanation of the forming processes. Also, the processes similar to those of the method of manufacturing the light detection device 1 according to the above-described first embodiment of the present technology will not be discussed further.

First, in the state of the first embodiment depicted in FIG. 5E, a known deposition technique or the like is used to form the insulating film 64, thereby obtaining the state illustrated in FIG. 10A. Then, as depicted in FIG. 10B, a film m5Aa including the first material is stacked in a manner covering the exposed surfaces including the side walls and the bottom of the trenches 24a. A film m5Ab including the second material is further stacked in a manner filling the trenches 24a.

Thereafter, as depicted in FIG. 10C, a known etch-back technique, the CMP (Chemical Mechanical Polishing) method, or the like may be used, for example, to planarize the exposed surfaces by removing excess portions of the first and second materials as well as the film m1 serving as the hard mask. This leaves intact those portions of the films m5Aa and m5Ab which are embedded in the trenches 24a. The remaining portions make up the first layer 62Aa and the second layer 62Ab of the second separation part 62A. The subsequent manufacturing processes are similar to those explained above in connection with the first embodiment and thus will not be discussed further.

### <<Major advantageous effects of the second embodiment>>

The light detection device 1 according to the second embodiment also provides advantageous effects similar to those of the light detection device 1 according to the first embodiment discussed above.

Also, in the light detection device 1 according to the second embodiment, the thickness of the first layer 62Aa in the stacking direction is less than in the case of the first embodiment. This further suppresses the influence of silicon nitride on the semiconductor layer 20.

Furthermore, in the light detection device 1 according to the second embodiment, the first layer 62Aa has both the facing part 62Aa1 and the side wall part 62Aa2. This means that, even when the thickness of the first layer 62Aa in the stacking direction is less than in the case of the first embodiment, the etchant used to remove the sacrificial layer M is prevented from reaching the second layer 62Ab inside the first layer 62Aa. This prevents the second separation part 62A from being etched.

It is to be noted that the insulating film 64 formed in the process depicted in FIG. 10A may be formed following removal of the sacrificial layer M.

### <<Modification examples of the second embodiment>>

### <Modification example 2-1>

In the second embodiment of the present technology, the first separation part 61 includes silicon oxide. However, this is not limitative of the present technology. As depicted in FIG. 11, the first separation part 61 may alternatively have a multilayer structure in which the portion 61a including silicon oxide and the portion 61b including metal are stacked in this order. The metal making up the portion 61b may be, but is not limited to, aluminum or tungsten, for example.

The light detection device 1 according to the modification example 2-1 also provides advantageous effects similar to those of the light detection device 1 according to the second embodiment discussed above.

Also, in the light detection device 1 according to the modification example 2-1, the first separation part 61 has the portion 61b including metal. This makes it possible further to suppress color mixing between the photoelectric conversion regions 20a.

### <Modification example 2-2>

In the above-described second embodiment, the first layer 62Aa has both the facing part 62Aa1 and the side wall part 62Aa2 as depicted in FIG. 9A. Alternatively, only the facing part 62Aa1 may be provided.

In the light detection device 1 according to the modification example 2-2, the facing part 62Aa1 forms the first surface S3. This makes it possible to prevent the second separation part 62A from being etched upon removal of the sacrificial layer M.

### <Modification example 2-3>

Whereas the separation parts 60 in the second embodiment of the present technology provide the FTI, this is not limitative of this technology. Alternatively, as depicted in FIG. 12, the second separation part 62A may provide the STI (Shallow Trench Isolation). More specifically, the second separation part 62A may have a horizontal size greater than that of the first separation part 61. The second separation part 62A has a multilayer structure in which a first layer 62Ac including the first material and forming the first surface S3 and a second layer 62Ad including the second material different from the first material are stacked. The first layer 62Ac is formed in a region where there is an overlap at least with the first separation part 61 in the thickness direction (i.e., an overlap in planar view).

The light detection device 1 according to the modification example 2-3 also provides advantageous effects similar to those of the light detection device 1 according to the second embodiment discussed above.

### <Modification example 2-4>

In the above-described second embodiment and in its modification examples, the second material making up the second layer 62Ab or 62Ad in FIGS. 9A, 11, and 12 is an insulating material. However, this is not limitative of the present technology. Alternatively, the second material may be a conductive material such as polysilicon.

The light detection device 1 according to the modification example 2-4 also provides advantageous effects similar to those of the light detection device 1 according to the second embodiment discussed above.

When the second layer 62Ab or 62Ad includes the conductive material, the second separation part 62A may be used as an electrode. This improves the degree of freedom in design.

### [Third embodiment]

A third embodiment of the present technology depicted in FIG. 13 is explained below. The light detection device 1 according to the third embodiment differs from the light detection device 1 according to the first embodiment above in that a second separation part 62B is provided in place of the second separation part 62. The remaining configuration of the light detection device 1 is basically similar to the configuration of the light detection device 1 according to the first embodiment discussed above. The constituent elements explained already are designated by the same reference signs and will not be discussed further.

### <Separation parts>

The separation parts 60 each include the first separation part 61 positioned closer to the side of the light incident surface S2 and the second separation part 62B positioned closer to the side of the element forming surface S1 in the thickness direction of the light detection device 1. The trenches 24 in which the separation parts 60 are formed include a first trench 24c positioned closer to the side of the element forming surface S1 and constituting the STI and a second trench 24d positioned closer to the side of the light incident surface S2 and constituting the FTI. It is to be noted that, in the case where the first trench 24c and the second trench 24d are not distinguished from each other, they are simply referred to as the trenches 24.

The second separation part 62B is provided in a region ranging from the first trench 24c to a portion of the second trench 24d. Further, the second separation part 62B has a multilayer structure in which a first layer 62Ba including the first material and constituting the first surface S3 and a second layer 62Bb including the second material different from the first material are stacked. The first layer 62Ba is formed in a portion of the second trench 24d. More specifically, the first layer 62Ba is provided in a portion closer to the first trench 24c inside the second trench 24d. The second layer 62Bb is formed in the first trench 24c constituting the STI. That is, the first layer 62Ba has a horizontal size equal to that of the first separation part 61, and the second layer 62Bb has a horizontal size greater than that of the first separation part 61. The second separation part 62B has the first surface S3 closer to the above-mentioned first separation part 61 and the second surface S4 opposite to the side of the first surface S3. The first surface S3 functions as an etching stop surface. The second surface S4 of the second separation part 62B (second layer 62Bb) faces the element forming surface S1.

The first material is silicon doped with impurities. More specifically, the first material may be, but is not limited to, polysilicon doped with impurities, for example. The impurities may be boron (B), for example, but are not limited thereto. The concentration of boron in the first material is 5×10¹⁸ atoms/cm³ or higher. The second material is an insulating material such as silicon oxide, for example, but is not limited thereto.

### <<Method of manufacturing the light detection device>>

A method of manufacturing the light detection device 1 is explained below with reference to FIGS. 14A through 14G. It is to be noted that what is described below are primarily the processes of forming the separation parts 60. For this reason, those constituent elements of the light detection device 1 which can be formed by known methods may be omitted from the explanation of the forming processes. Also, the processes similar to those of the method of manufacturing the light detection device 1 according to the above-described first embodiment of the present technology will not be discussed further.

As depicted in FIG. 14A, the first trench 24c constituting the STI and the second trench 24d constituting the FTI are formed in the semiconductor layer 20w. Then, as depicted in FIG. 14B, the film m3 including silicon oxide is stacked in a manner covering the exposed surfaces including the side walls and the bottom of the trenches 24. Further, the film m4 forming a sacrificial layer is stacked in the trenches 24. The sacrificial layer includes polysilicon, for example.

Next, as depicted in FIG. 14C, a known etch-back technique is used to remove the film m4 stacked in the first trench 24c. Then, as illustrated in FIG. 14D, impurities are injected near the exposed surface of the film m4 including polysilicon and remaining in the trenches 24. Here, boron is injected. The first material is thus obtained by injecting boron into the polysilicon. Of the film m4, the region doped with the impurities forms the first layer 62Ba, and the remaining portions make up the sacrificial layer M.

Then, as depicted in FIG. 14E, a film m7 including silicon oxide is stacked in a manner filling the inside of the first trench 24c. Thereafter, an excess insulating film on the side of the element forming surface S1 is removed, and the processes explained in conjunction with the first embodiment and depicted in FIGS. 5H and 5I are carried out. The semiconductor layer 20w having the wiring layer 30 and the support substrate 40 formed therein is turned upside down as depicted in FIG. 14F. The semiconductor layer 20w is made thinner from the surface opposite to the side of the element forming surface S1 in order to expose the sacrificial layer M stacked inside the second trench 24d.

Next, as depicted in FIG. 14G, a known etching technique is used to etch the sacrificial layer M from the side of the light incident surface S2. This removes the sacrificial layer M embedded in the trenches 24. At this point, the first surface S3 functions as an etching stop surface. More specifically, the first material (polysilicon doped with boron) constituting the first layer 62Ba and its first surface S3 is a material of which the etching rate relative to the selected etchant is lower than that of the material forming the sacrificial layer M (polysilicon in this embodiment). Consequently, the first surface S3 is hardly or not at all etched. As a result, solely the sacrificial layer M can be removed while the first layer 62Ba including the first material is left intact. It is to be noted that, for example, hydrogen fluoride can be used as the etchant but is not limitative. The subsequent processes are similar to those explained above in connection with the first embodiment and thus will not be discussed further.

### <<Major advantageous effects of the third embodiments

The light detection device 1 according to the third embodiment also provides advantageous effects similar to those of the light detection device 1 according to the first embodiment discussed above.

### <<Modification examples of the third embodiments

### <Modification example 3-1>

In the third embodiment of the present technology, the first material constituting the second separation part 62B is doped with boron. However, this is not limitative of the present technology. Alternatively, the first material may be doped with boron and carbon (C). For example, in the process depicted in FIG. 14D, boron and carbon are injected into the film m4 including polysilicon. Carbon is injected to control the diffusion of boron.

The light detection device 1 according to the modification example 3-1 also provides advantageous effects similar to those of the light detection device 1 according to the third embodiment discussed above.

### <Modification example 3-2>

In the third embodiment of the present technology, the first material is formed by injection of boron after the film m4 including polysilicon is etched back. However, this is not limitative of the present technology. Alternatively, a film m8 including the first material may be stacked by forming a silicon film (e.g., polysilicon film) through the mixture of impurities after the film m4 is etched back, as depicted in FIG. 15. Thereafter, excess portions of the film m8 are etched back to leave intact the portions corresponding to the first layer 62Ba.

The light detection device 1 according to the modification example 3-2 also provides advantageous effects similar to those of the light detection device 1 according to the third embodiment discussed above.

### <Modification example 3-3>

In the third embodiment of the present technology, the first separation part 61 includes silicon oxide. However, this is not limitative of the present technology. As depicted in FIG 16, the first separation part 61 may alternatively have a multilayer structure in which the portion 61a including silicon oxide and the portion 61b including metal are stacked in this order. The metal constituting the portion 61b may be metal such as aluminum or tungsten, for example, but is not limited thereto.

The light detection device 1 according to the modification example 3-3 also provides advantageous effects similar to those of the light detection device 1 according to the third embodiment discussed above.

Since the first separation part 61 in the light detection device 1 according to the modification example 3-3 has the portion 61b including metal, it is possible further to suppress color mixing between the photoelectric conversion regions 20a.

### <Modification example 3-4>

In the third embodiment of the present technology, the separation parts 60 have both the portions constituting the FTI and the portions constituting the STI. However, this is not limitative of the present technology. Alternatively, the separation parts 60 may only have the portions constituting the FTI.

The light detection device 1 according to the modification example 3-4 also provides advantageous effects similar to those of the light detection device 1 according to the third embodiment discussed above.

### [Fourth embodiment]

### <1. Example of application to electronic equipment>

Explained next is electronic equipment 100 depicted in FIG. 17 according to a fourth embodiment of the present technology. The electronic equipment 100 includes a solid-state imaging device 101, an optical lens 102, a shutter device 103, a drive circuit 104, and a signal processing circuit 105. For example, the electronic equipment 100 may be electronic equipment such as a camera, but is not limited thereto. Further, the electronic equipment 100 has the light detection device 1 as the solid-state imaging device 101.

The optical lens (optical system) 102 forms an image of image light (incident light 106) from a subject on an imaging plane of the solid-state imaging device 101. This causes the solid-state imaging device 101 to accumulate signal charges for a predetermined time period. The shutter device 103 controls a light irradiation period and a light blocking period for the solid-state imaging device 101. The drive circuit 104 supplies a drive signal to control both the solid-state imaging device 101 for a transfer operation and the shutter device 103 for a shutter operation. The drive signal (timing signal) supplied from the drive circuit 104 causes the solid-state imaging device 101 to transfer signals. The signal processing circuit 105 performs various types of signal processing on the signals (pixel signals) output from the solid-state imaging device 101. Video signals resulting from the signal processing are stored in a storage medium such as a memory or output to a monitor.

In the electronic equipment 100 configured as described above, the solid-state imaging device 101 has the first surface S3 of the second separation part 62 faced with the first material that suppresses the etching of the second separation part 62, the first surface S3 being positioned closer to the first separation part 61. This makes it possible to suppress the worsening of noise characteristics.

It is to be noted that the electronic equipment 100 is not limited to the camera and may be any other electric devices. For example, the electronic equipment 100 may be an imaging device such as a camera module for mobile devices such as mobile phones.

Also, the electronic equipment 100 can have, as the solid-state imaging device 101, the light detection device 1 according to any one of the first through third embodiments and their modification examples, or the light detection device 1 according to a combination of at least two of the first through third embodiments and their modification examples.

### <2. Example of application to mobile bodies>

The technology according to the present disclosure (the present technology) can be applied to diverse products. For example, the technology according to the present disclosure may be implemented as a device to be mounted on such mobile bodies as automobiles, electric vehicles, hybrid electric vehicles, motorcycles, bicycles, personal mobility devices, aircraft, drones, ships, and robots.

FIG. 18 is a block diagram depicting an example of schematic configuration of a vehicle control system as an example of a mobile body control system to which the technology according to an embodiment of the present disclosure can be applied.

The vehicle control system 12000 includes a plurality of electronic control units connected to each other via a communication network 12001. In the example depicted in FIG. 18, the vehicle control system 12000 includes a driving system control unit 12010, a body system control unit 12020, an outside-vehicle information detecting unit 12030, an in-vehicle information detecting unit 12040, and an integrated control unit 12050. In addition, a microcomputer 12051, a sound/image output section 12052, and a vehicle-mounted network interface (I/F) 12053 are illustrated as a functional configuration of the integrated control unit 12050.

The driving system control unit 12010 controls the operation of devices related to the driving system of the vehicle in accordance with various kinds of programs. For example, the driving system control unit 12010 functions as a control device for a driving force generating device for generating the driving force of the vehicle, such as an internal combustion engine, a driving motor, or the like, a driving force transmitting mechanism for transmitting the driving force to wheels, a steering mechanism for adjusting the steering angle of the vehicle, a braking device for generating the braking force of the vehicle, and the like.

The body system control unit 12020 controls the operation of various kinds of devices provided to a vehicle body in accordance with various kinds of programs. For example, the body system control unit 12020 functions as a control device for a keyless entry system, a smart key system, a power window device, or various kinds of lamps such as a headlamp, a backup lamp, a brake lamp, a turn signal, a fog lamp, or the like. In this case, radio waves transmitted from a mobile device as an alternative to a key or signals of various kinds of switches can be input to the body system control unit 12020. The body system control unit 12020 receives these input radio waves or signals, and controls a door lock device, the power window device, the lamps, or the like of the vehicle.

The outside-vehicle information detecting unit 12030 detects information about the outside of the vehicle including the vehicle control system 12000. For example, the outside-vehicle information detecting unit 12030 is connected with an imaging section 12031. The outside-vehicle information detecting unit 12030 makes the imaging section 12031 image an image of the outside of the vehicle, and receives the imaged image. On the basis of the received image, the outside-vehicle information detecting unit 12030 may perform processing of detecting an object such as a human, a vehicle, an obstacle, a sign, a character on a road surface, or the like, or processing of detecting a distance thereto.

The imaging section 12031 is an optical sensor that receives light, and which outputs an electric signal corresponding to a received light amount of the light. The imaging section 12031 can output the electric signal as an image, or can output the electric signal as information about a measured distance. In addition, the light received by the imaging section 12031 may be visible light, or may be invisible light such as infrared rays or the like.

The in-vehicle information detecting unit 12040 detects information about the inside of the vehicle. The in-vehicle information detecting unit 12040 is, for example, connected with a driver state detecting section 12041 that detects the state of a driver. The driver state detecting section 12041, for example, includes a camera that images the driver. On the basis of detection information input from the driver state detecting section 12041, the in-vehicle information detecting unit 12040 may calculate a degree of fatigue of the driver or a degree of concentration of the driver, or may determine whether the driver is dozing.

The microcomputer 12051 can calculate a control target value for the driving force generating device, the steering mechanism, or the braking device on the basis of the information about the inside or outside of the vehicle which information is obtained by the outside-vehicle information detecting unit 12030 or the in-vehicle information detecting unit 12040, and output a control command to the driving system control unit 12010. For example, the microcomputer 12051 can perform cooperative control intended to implement functions of an advanced driver assistance system (ADAS) which functions include collision avoidance or shock mitigation for the vehicle, following driving based on a following distance, vehicle speed maintaining driving, a warning of collision of the vehicle, a warning of deviation of the vehicle from a lane, or the like.

In addition, the microcomputer 12051 can perform cooperative control intended for automated driving, which makes the vehicle to travel automatedly without depending on the operation of the driver, or the like, by controlling the driving force generating device, the steering mechanism, the braking device, or the like on the basis of the information about the outside or inside of the vehicle which information is obtained by the outside-vehicle information detecting unit 12030 or the in-vehicle information detecting unit 12040.

In addition, the microcomputer 12051 can output a control command to the body system control unit 12020 on the basis of the information about the outside of the vehicle which information is obtained by the outside-vehicle information detecting unit 12030. For example, the microcomputer 12051 can perform cooperative control intended to prevent a glare by controlling the headlamp so as to change from a high beam to a low beam, for example, in accordance with the position of a preceding vehicle or an oncoming vehicle detected by the outside-vehicle information detecting unit 12030.

The sound/image output section 12052 transmits an output signal of at least one of a sound and an image to an output device capable of visually or auditorily notifying information to an occupant of the vehicle or the outside of the vehicle. In the example of FIG. 18, an audio speaker 12061, a display section 12062, and an instrument panel 12063 are illustrated as the output device. The display section 12062 may, for example, include at least one of an on-board display and a head-up display.

FIG. 19 is a diagram depicting an example of the installation position of the imaging section 12031.

In FIG. 19, the imaging section 12031 includes imaging sections 12101, 12102, 12103, 12104, and 12105.

The imaging sections 12101, 12102, 12103, 12104, and 12105 are, for example, disposed at positions on a front nose, sideview mirrors, a rear bumper, and a back door of the vehicle 12100 as well as a position on an upper portion of a windshield within the interior of the vehicle. The imaging section 12101 provided to the front nose and the imaging section 12105 provided to the upper portion of the windshield within the interior of the vehicle obtain mainly an image of the front of the vehicle 12100. The imaging sections 12102 and 12103 provided to the sideview mirrors obtain mainly an image of the sides of the vehicle 12100. The imaging section 12104 provided to the rear bumper or the back door obtains mainly an image of the rear of the vehicle 12100. The imaging section 12105 provided to the upper portion of the windshield within the interior of the vehicle is used mainly to detect a preceding vehicle, a pedestrian, an obstacle, a signal, a traffic sign, a lane, or the like.

Incidentally, FIG. 19 depicts an example of photographing ranges of the imaging sections 12101 to 12104. An imaging range 12111 represents the imaging range of the imaging section 12101 provided to the front nose. Imaging ranges 12112 and 12113 respectively represent the imaging ranges of the imaging sections 12102 and 12103 provided to the sideview mirrors. An imaging range 12114 represents the imaging range of the imaging section 12104 provided to the rear bumper or the back door. A bird's-eye image of the vehicle 12100 as viewed from above is obtained by superimposing image data imaged by the imaging sections 12101 to 12104, for example.

At least one of the imaging sections 12101 to 12104 may have a function of obtaining distance information. For example, at least one of the imaging sections 12101 to 12104 may be a stereo camera constituted of a plurality of imaging elements, or may be an imaging element having pixels for phase difference detection.

For example, the microcomputer 12051 can determine a distance to each three-dimensional object within the imaging ranges 12111 to 12114 and a temporal change in the distance (relative speed with respect to the vehicle 12100) on the basis of the distance information obtained from the imaging sections 12101 to 12104, and thereby extract, as a preceding vehicle, a nearest three-dimensional object in particular that is present on a traveling path of the vehicle 12100 and which travels in substantially the same direction as the vehicle 12100 at a predetermined speed (for example, equal to or more than 0 km/hour). Further, the microcomputer 12051 can set a following distance to be maintained in front of a preceding vehicle in advance, and perform automatic brake control (including following stop control), automatic acceleration control (including following start control), or the like. It is thus possible to perform cooperative control intended for automated driving that makes the vehicle travel automatedly without depending on the operation of the driver or the like.

For example, the microcomputer 12051 can classify three-dimensional object data on three-dimensional objects into three-dimensional object data of a two-wheeled vehicle, a standard-sized vehicle, a large-sized vehicle, a pedestrian, a utility pole, and other three-dimensional objects on the basis of the distance information obtained from the imaging sections 12101 to 12104, extract the classified three-dimensional object data, and use the extracted three-dimensional object data for automatic avoidance of an obstacle. For example, the microcomputer 12051 identifies obstacles around the vehicle 12100 as obstacles that the driver of the vehicle 12100 can recognize visually and obstacles that are difficult for the driver of the vehicle 12100 to recognize visually. Then, the microcomputer 12051 determines a collision risk indicating a risk of collision with each obstacle. In a situation in which the collision risk is equal to or higher than a set value and there is thus a possibility of collision, the microcomputer 12051 outputs a warning to the driver via the audio speaker 12061 or the display section 12062, and performs forced deceleration or avoidance steering via the driving system control unit 12010. The microcomputer 12051 can thereby assist in driving to avoid collision.

At least one of the imaging sections 12101 to 12104 may be an infrared camera that detects infrared rays. The microcomputer 12051 can, for example, recognize a pedestrian by determining whether or not there is a pedestrian in imaged images of the imaging sections 12101 to 12104. Such recognition of a pedestrian is, for example, performed by a procedure of extracting characteristic points in the imaged images of the imaging sections 12101 to 12104 as infrared cameras and a procedure of determining whether or not it is the pedestrian by performing pattern matching processing on a series of characteristic points representing the contour of the object. When the microcomputer 12051 determines that there is a pedestrian in the imaged images of the imaging sections 12101 to 12104, and thus recognizes the pedestrian, the sound/image output section 12052 controls the display section 12062 so that a square contour line for emphasis is displayed so as to be superimposed on the recognized pedestrian. The sound/image output section 12052 may also control the display section 12062 so that an icon or the like representing the pedestrian is displayed at a desired position.

An example of the vehicle control system to which the technology according to the present disclosure can be applied has been explained above. For instance, the technology according to the present disclosure can be applied to the imaging section 12031 or the like from among the components discussed above. Specifically, the light detection device 1 depicted in FIG. 4 and other figures can be adopted as the imaging section 12031. Applying the technology according to the present disclosure to the imaging section 12031 can suppress the worsening of noise characteristics and thereby provide easier-to-view captured images. This in turn helps alleviate the fatigue of the driver.

### <3. Example of application to an endoscopic surgery system>

The technology according to the present disclosure (present technology) can be applied to diverse products. For example, the technology according to the present disclosure may be applied to an endoscopic surgery system.

FIG. 20 is a view depicting an example of a schematic configuration of an endoscopic surgery system to which the technology according to an embodiment of the present disclosure (present technology) can be applied.

In FIG. 20, a state is illustrated in which a surgeon (medical doctor) 11131 is using an endoscopic surgery system 11000 to perform surgery for a patient 11132 on a patient bed 11133. As depicted, the endoscopic surgery system 11000 includes an endoscope 11100, other surgical tools 11110 such as a pneumoperitoneum tube 11111 and an energy device 11112, a supporting arm apparatus 11120 which supports the endoscope 11100 thereon, and a cart 11200 on which various apparatus for endoscopic surgery are mounted.

The endoscope 11100 includes a lens barrel 11101 having a region of a predetermined length from a distal end thereof to be inserted into a body cavity of the patient 11132, and a camera head 11102 connected to a proximal end of the lens barrel 11101. In the example depicted, the endoscope 11100 is depicted which includes as a rigid endoscope having the lens barrel 11101 of the hard type. However, the endoscope 11100 may otherwise be included as a flexible endoscope having the lens barrel 11101 of the flexible type.

The lens barrel 11101 has, at a distal end thereof, an opening in which an objective lens is fitted. A light source apparatus 11203 is connected to the endoscope 11100 such that light generated by the light source apparatus 11203 is introduced to a distal end of the lens barrel 11101 by a light guide extending in the inside of the lens barrel 11101 and is irradiated toward an observation target in a body cavity of the patient 11132 through the objective lens. It is to be noted that the endoscope 11100 may be a forward-viewing endoscope or may be an oblique-viewing endoscope or a side-viewing endoscope.

An optical system and an image pickup element are provided in the inside of the camera head 11102 such that reflected light (observation light) from the observation target is condensed on the image pickup element by the optical system. The observation light is photo-electrically converted by the image pickup element to generate an electric signal corresponding to the observation light, namely, an image signal corresponding to an observation image. The image signal is transmitted as RAW data to a CCU 11201.

The CCU 11201 includes a central processing unit (CPU), a graphics processing unit (GPU) or the like and integrally controls operation of the endoscope 11100 and a display apparatus 11202. Further, the CCU 11201 receives an image signal from the camera head 11102 and performs, for the image signal, various image processes for displaying an image based on the image signal such as, for example, a development process (demosaic process).

The display apparatus 11202 displays thereon an image based on an image signal, for which the image processes have been performed by the CCU 11201, under the control of the CCU 11201.

The light source apparatus 11203 includes a light source such as, for example, a light emitting diode (LED) and supplies irradiation light upon imaging of a surgical region to the endoscope 11100.

An inputting apparatus 11204 is an input interface for the endoscopic surgery system 11000. A user can perform inputting of various kinds of information or instruction inputting to the endoscopic surgery system 11000 through the inputting apparatus 11204. For example, the user would input an instruction or a like to change an image pickup condition (type of irradiation light, magnification, focal distance or the like) by the endoscope 11100.

A treatment tool controlling apparatus 11205 controls driving of the energy device 11112 for cautery or incision of a tissue, sealing of a blood vessel or the like. A pneumoperitoneum apparatus 11206 feeds gas into a body cavity of the patient 11132 through the pneumoperitoneum tube 11111 to inflate the body cavity in order to secure the field of view of the endoscope 11100 and secure the working space for the surgeon. A recorder 11207 is an apparatus capable of recording various kinds of information relating to surgery. A printer 11208 is an apparatus capable of printing various kinds of information relating to surgery in various forms such as a text, an image or a graph.

It is to be noted that the light source apparatus 11203 which supplies irradiation light when a surgical region is to be imaged to the endoscope 11100 may include a white light source which includes, for example, an LED, a laser light source or a combination of them. Where a white light source includes a combination of red, green, and blue (RGB) laser light sources, since the output intensity and the output timing can be controlled with a high degree of accuracy for each color (each wavelength), adjustment of the white balance of a picked up image can be performed by the light source apparatus 11203. Further, in this case, if laser beams from the respective RGB laser light sources are irradiated time-divisionally on an observation target and driving of the image pickup elements of the camera head 11102 are controlled in synchronism with the irradiation timings. Then images individually corresponding to the R, G and B colors can be also picked up time-divisionally. According to this method, a color image can be obtained even if color filters are not provided for the image pickup element.

Further, the light source apparatus 11203 may be controlled such that the intensity of light to be outputted is changed for each predetermined time. By controlling driving of the image pickup element of the camera head 11102 in synchronism with the timing of the change of the intensity of light to acquire images time-divisionally and synthesizing the images, an image of a high dynamic range free from underexposed blocked up shadows and overexposed highlights can be created.

Further, the light source apparatus 11203 may be configured to supply light of a predetermined wavelength band ready for special light observation. In special light observation, for example, by utilizing the wavelength dependency of absorption of light in a body tissue to irradiate light of a narrow band in comparison with irradiation light upon ordinary observation (namely, white light), narrow band observation (narrow band imaging) of imaging a predetermined tissue such as a blood vessel of a superficial portion of the mucous membrane or the like in a high contrast is performed. Alternatively, in special light observation, fluorescent observation for obtaining an image from fluorescent light generated by irradiation of excitation light may be performed. In fluorescent observation, it is possible to perform observation of fluorescent light from a body tissue by irradiating excitation light on the body tissue (autofluorescence observation) or to obtain a fluorescent light image by locally injecting a reagent such as indocyanine green (ICG) into a body tissue and irradiating excitation light corresponding to a fluorescent light wavelength of the reagent upon the body tissue. The light source apparatus 11203 can be configured to supply such narrowband light and/or excitation light suitable for special light observation as described above.

FIG. 21 is a block diagram depicting an example of a functional configuration of the camera head 11102 and the CCU 11201 depicted in FIG. 20.

The camera head 11102 includes a lens unit 11401, an image pickup unit 11402, a driving unit 11403, a communication unit 11404 and a camera head controlling unit 11405. The CCU 11201 includes a communication unit 11411, an image processing unit 11412 and a control unit 11413. The camera head 11102 and the CCU 11201 are connected for communication to each other by a transmission cable 11400.

The lens unit 11401 is an optical system, provided at a connecting location to the lens barrel 11101. Observation light taken in from a distal end of the lens barrel 11101 is guided to the camera head 11102 and introduced into the lens unit 11401. The lens unit 11401 includes a combination of a plurality of lenses including a zoom lens and a focusing lens.

The number of image pickup elements which is included by the image pickup unit 11402 may be one (single-plate type) or a plural number (multi-plate type). Where the image pickup unit 11402 is configured as that of the multi-plate type, for example, image signals corresponding to respective R, G and B are generated by the image pickup elements, and the image signals may be synthesized to obtain a color image. The image pickup unit 11402 may also be configured so as to have a pair of image pickup elements for acquiring respective image signals for the right eye and the left eye ready for three dimensional (3D) display. If 3D display is performed, then the depth of a living body tissue in a surgical region can be comprehended more accurately by the surgeon 11131. It is to be noted that, where the image pickup unit 11402 is configured as that of stereoscopic type, a plurality of systems of lens units 11401 are provided corresponding to the individual image pickup elements.

Further, the image pickup unit 11402 may not necessarily be provided on the camera head 11102. For example, the image pickup unit 11402 may be provided immediately behind the objective lens in the inside of the lens barrel 11101.

The driving unit 11403 includes an actuator and moves the zoom lens and the focusing lens of the lens unit 11401 by a predetermined distance along an optical axis under the control of the camera head controlling unit 11405. Consequently, the magnification and the focal point of a picked up image by the image pickup unit 11402 can be adjusted suitably.

The communication unit 11404 includes a communication apparatus for transmitting and receiving various kinds of information to and from the CCU 11201. The communication unit 11404 transmits an image signal acquired from the image pickup unit 11402 as RAW data to the CCU 11201 through the transmission cable 11400.

In addition, the communication unit 11404 receives a control signal for controlling driving of the camera head 11102 from the CCU 11201 and supplies the control signal to the camera head controlling unit 11405. The control signal includes information relating to image pickup conditions such as, for example, information that a frame rate of a picked up image is designated, information that an exposure value upon image picking up is designated and/or information that a magnification and a focal point of a picked up image are designated.

It is to be noted that the image pickup conditions such as the frame rate, exposure value, magnification or focal point may be designated by the user or may be set automatically by the control unit 11413 of the CCU 11201 on the basis of an acquired image signal. In the latter case, an auto exposure (AE) function, an auto focus (AF) function and an auto white balance (AWB) function are incorporated in the endoscope 11100.

The camera head controlling unit 11405 controls driving of the camera head 11102 on the basis of a control signal from the CCU 11201 received through the communication unit 11404.

The communication unit 11411 includes a communication apparatus for transmitting and receiving various kinds of information to and from the camera head 11102. The communication unit 11411 receives an image signal transmitted thereto from the camera head 11102 through the transmission cable 11400.

Further, the communication unit 11411 transmits a control signal for controlling driving of the camera head 11102 to the camera head 11102. The image signal and the control signal can be transmitted by electrical communication, optical communication or the like.

The image processing unit 11412 performs various image processes for an image signal in the form of RAW data transmitted thereto from the camera head 11102.

The control unit 11413 performs various kinds of control relating to image picking up of a surgical region or the like by the endoscope 11100 and display of a picked up image obtained by image picking up of the surgical region or the like. For example, the control unit 11413 creates a control signal for controlling driving of the camera head 11102.

Further, the control unit 11413 controls, on the basis of an image signal for which image processes have been performed by the image processing unit 11412, the display apparatus 11202 to display a picked up image in which the surgical region or the like is imaged. Thereupon, the control unit 11413 may recognize various objects in the picked up image using various image recognition technologies. For example, the control unit 11413 can recognize a surgical tool such as forceps, a particular living body region, bleeding, mist when the energy device 11112 is used and so forth by detecting the shape, color and so forth of edges of objects included in a picked up image. The control unit 11413 may cause, when it controls the display apparatus 11202 to display a picked up image, various kinds of surgery supporting information to be displayed in an overlapping manner with an image of the surgical region using a result of the recognition. Where surgery supporting information is displayed in an overlapping manner and presented to the surgeon 11131, the burden on the surgeon 11131 can be reduced and the surgeon 11131 can proceed with the surgery with certainty.

The transmission cable 11400 which connects the camera head 11102 and the CCU 11201 to each other is an electric signal cable ready for communication of an electric signal, an optical fiber ready for optical communication or a composite cable ready for both of electrical and optical communications.

Here, while, in the example depicted, communication is performed by wired communication using the transmission cable 11400, the communication between the camera head 11102 and the CCU 11201 may be performed by wireless communication.

An example of the endoscopic surgery system to which the technology according to the present disclosure can be applied has been explained above. For example, the technology according to the present disclosure can be applied to the image pickup unit 11402 of the camera head 11102 from among the components discussed above. Specifically, the light detection device 1 depicted in FIG. 4 and other figures can be adopted as the image pickup unit 10402. Applying the technology according to the present disclosure to the camera head 11102 can suppress the worsening of noise characteristics and thereby provide clearer images of the surgical region. This in turn allows the surgeon to reliably verify the surgical region.

It is to be noted that, whereas the endoscopic surgery system has been explained above as an example, the technology according to the present disclosure may also be applied to a microscopic surgery system, for instance.

### [Other embodiments]

Whereas the present technology has been described above in conjunction with the first through fourth embodiments thereof, the statements and the drawings constituting portions of this disclosure should not be construed as being limitative of the present technology. Many alternative embodiments, alternative working examples, and alternative operation technologies will become apparent to those skilled in the art in light of the present disclosure.

For example, the technical ideas explained above in connection with the first through fourth embodiments may be combined as desired. For instance, whereas the first material making up the second separation part 62B in the light detection device 1 according to the third embodiment above is silicon doped with impurities, such a technical idea may also be applied to the light detection device 1 described in the first and second embodiments. Further, whereas, in the light detection device 1 according to the second embodiment above, the first material is any one of polysilicon, silicon oxide, hafnium oxide, and aluminum oxide, such a technical idea may also be applied to the first material of the first embodiment. Further, whereas the light detection device 1 according to the second embodiment above has the insulating film 64 separating the second separation part 62A from the fixed charge film 51, such a technical idea may also be applied to the light detection device 1 described in the first and third embodiments. In this manner, the embodiments and their variations may be diversely combined in accordance with each of the technical ideas.

Moreover, the present technology can be applied not only to the above-described solid-state imaging device as the image sensor but also to a whole range of light detection devices including distance measuring sensors also called ToF (Time of Flight) sensors that measure distances. The distance measuring sensor is a sensor that emits irradiation light to an object, detects reflected light from a surface of the object, and calculates the distance to the object based on the time of flight of the irradiation light from its emission to its return as reflected light. The structure of the above-described separation parts 60 can be adopted as the structure of the distance measuring sensor.

Further, in a case where a plurality of photoelectric conversion elements PD are configured in one photoelectric conversion region 20a for autofocus purposes, for example, the separation parts 60 may partition these photoelectric conversion elements PD configured in the one photoelectric conversion region 20a.

Also, the light detection device 1 may be a multilayer CIS (CMOS Image Sensor) in which two or more semiconductor substrates are stacked one on top of another. In this case, at least either the logic circuit 13 or the readout circuit 15 may be mounted on a semiconductor substrate different from the one on which the photoelectric conversion regions 20a are formed.

As described above, the present technology naturally includes various embodiments not described herein. Therefore, the technical scope of the present technology is defined only by the inventionspecifying matters according to the scope of claims reasonable from the above description.

Furthermore, the advantageous effects stated in this description are only examples and are not limitative. There may be other advantageous effects.

It is to be noted that the present technology may adopt the following configurations.
(1) A light detection device including:
   a semiconductor layer having photoelectric conversion regions, one surface of the semiconductor layer forming a light incident surface, another surface of the semiconductor layer forming an element forming surface;
   a trench positioned to partition the photoelectric conversion regions and penetrating the semiconductor layer in a direction of thickness thereof; and
   a separation part formed in the trench and including a first separation part and a second separation part, the first separation part being positioned on the side of the light incident surface, the second separation part being positioned on the side of the element forming surface,
   in which a first surface of the second separation part on the side of the first separation part faces a first material.
(2) The light detection device according to (1), in which the first material includes silicon nitride.
(3) The light detection device according to (1), in which the first material includes a material resistant to hydrogen fluoride.
(4) The light detection device according to (1) or (3), in which the first material includes either titanium nitride or tungsten.
(5) The light detection device according to (1), in which the first material includes any one of polysilicon, silicon oxide, hafnium oxide, and aluminum oxide.
(6) The light detection device according to (1), in which the first material includes silicon doped with impurities.
(7) The light detection device according to (6),
   in which the impurities include boron, and
   the first material includes silicon doped with boron at a concentration of 5×10¹⁸ atoms/cm³ or higher.
(8) The light detection device according to (6), in which the impurities include boron and carbon.
(9) The light detection device according to any one of (1) to (5), in which the second separation part includes the first material.
(10) The light detection device according to any one of (1) to (8), in which the second separation part has a multilayer structure in which a first layer including the first material and constituting the first surface and a second layer including a second material different from the first material are stacked.
(11) The light detection device according to (1),
   in which the second separation part has a horizontal size greater than that of the first separation part, and
   the first layer is formed in a region where there is an overlap at least with the first separation part in the thickness direction.
(12) The light detection device according to any one of (1) to (11), in which a distance between the first surface of the second separation part and the element forming surface is from 200 nm to 300 nm inclusive.
(13) The light detection device according to any one of (1) to (12), in which the first material includes a material that suppresses etching of the second separation part.
(14) The light detection device according to any one of (1) to (13), including:
   a fixed charge film,
   in which the fixed charge film is interposed at least between the first separation part and the second separation part.
(15) The light detection device according to (14), further including:
   a silicon oxide film interposed between the second separation part and the fixed charge film.
(16) The light detection device according to (10), in which the second material includes an insulating material.
(17) The light detection device according to (10), in which the second material includes a conductive material.
(18) The light detection device according to any one of (1) to (17), in which, of a portion including silicon oxide and a portion including metal, the first separation part includes at least the portion including silicon oxide.
(19) A method of manufacturing a light detection device, including:
   forming a trench in a position to partition photoelectric conversion regions in a semiconductor layer from the side of an element forming surface thereof;
   stacking, in the trench, a sacrificial layer and a first material in this order in a direction of thickness of the semiconductor layer, the first material being a material of which an etching rate relative to a selected etchant is lower than that of a material constituting the sacrificial layer;
   exposing the sacrificial layer from the side of a light incident surface opposite to the side of the element forming surface;
   removing the sacrificial layer while leaving the first material intact, by use of the selected etchant; and
   embedding a material different from the material of the sacrificial layer into the trench from the side of the light incident surface.
(20) Electronic equipment including:
   a light detection device; and
   an optical system that causes the light detection device to form an image of image light from a subject,
   in which the light detection device includes
      a semiconductor layer having photoelectric conversion regions, one surface of the semiconductor layer forming a light incident surface, another surface of the semiconductor layer forming an element forming surface,
      a trench positioned to partition the photoelectric conversion regions and penetrating the semiconductor layer in a direction of thickness thereof, and
      a separation part formed in the trench and including a first separation part and a second separation part, the first separation part being positioned on the side of the light incident surface, the second separation part being positioned on the side of the element forming surface, and
   a first surface of the second separation part on the side of the first separation part faces a first material.

The scope of the present technology is not limited to the embodiments illustrated and described above as examples and includes all embodiments that provide advantageous effects equivalent to those intended by this technology. Furthermore, the scope of the present technology is not limited to the combinations of the features of this invention defined by the appended claims and can be determined by all desired combinations of specific ones of the features disclosed herein.

### [Reference Signs List]

- 1:: Light detection device
- 2:: Semiconductor chip
- 3:: Pixel
- 4:: Vertical drive circuit
- 5:: Column signal processing circuit
- 6:: Horizontal drive circuit
- 7:: Output circuit
- 8:: Control circuit
- 10:: Pixel drive line
- 11:: Vertical signal line
- 12:: Horizontal signal line
- 13:: Logic circuit
- 14:: Bonding pad
- 15:: Readout circuit
- 20:: Semiconductor layer
- 20a:: Photoelectric conversion region
- 20b:: Separation region
- 23:: Charge accumulation region
- 24, 24a, 24b:: Trench
- 24c:: First trench
- 24d:: Second trench
- 30:: Wiring layer
- 40:: Support substrate
- 50:: Light collecting layer
- 51:: Fixed charge film
- 52:: Insulating film
- 53:: Light blocking layer
- 54:: Planarizing film
- 55:: Color filter
- 56:: Micro lens
- 60:: Separation part
- 61, 61B:: First separation part
- 61a:: Portion
- 61b:: Portion
- 62, 62A, 62B:: Second separation part
- 62a, 62Aa, 62Ac, 62Ba:: First layer
- 62Aa1:: Facing part
- 62Aa2:: Side wall part
- 62b, 62Ab, 62Ad, 62Bb:: Second layer
- 63:: Insulating film
- 64:: Insulating film
- 100:: Electronic equipment
- 101:: Solid-state imaging device
- 102:: Optical system (optical lens)
- a:: Distance
- b:: Size
- M:: Sacrificial layer
- S1:: Element forming surface
- S2:: Light incident surface
- S3:: First surface
- S4:: Second surface

## Claims

1. A light detection device comprising:
a semiconductor layer having photoelectric conversion regions, one surface of the semiconductor layer forming a light incident surface, another surface of the semiconductor layer forming an element forming surface;
a trench positioned to partition the photoelectric conversion regions and penetrating the semiconductor layer in a direction of thickness thereof; and
a separation part formed in the trench and including a first separation part and a second separation part, the first separation part being positioned on a side of the light incident surface, the second separation part being positioned on a side of the element forming surface,
wherein a first surface of the second separation part on a side of the first separation part faces a first material.

2. The light detection device according to claim 1, wherein the first material includes silicon nitride.

3. The light detection device according to claim 1, wherein the first material includes a material resistant to hydrogen fluoride.

4. The light detection device according to claim 1, wherein the first material includes either titanium nitride or tungsten.

5. The light detection device according to claim 1, wherein the first material includes any one of polysilicon, silicon oxide, hafnium oxide, and aluminum oxide.

6. The light detection device according to claim 1, wherein the first material includes silicon doped with impurities.

7. The light detection device according to claim 6,
wherein the impurities include boron, and
the first material includes silicon doped with boron at a concentration of 5×10¹⁸ atoms/cm³ or higher.

8. The light detection device according to claim 6, wherein the impurities include boron and carbon.

9. The light detection device according to claim 1, wherein the second separation part includes the first material.

10. The light detection device according to claim 1, wherein the second separation part has a multilayer structure in which a first layer including the first material and constituting the first surface and a second layer including a second material different from the first material are stacked.

11. The light detection device according to claim 10,
wherein the second separation part has a horizontal size greater than that of the first separation part, and
the first layer is formed in a region where there is an overlap at least with the first separation part in the thickness direction.

12. The light detection device according to claim 1, wherein a distance between the first surface of the second separation part and the element forming surface is from 200 nm to 300 nm inclusive.

13. The light detection device according to claim 1, wherein the first material includes a material that suppresses etching of the second separation part.

14. The light detection device according to claim 1, comprising:
a fixed charge film,
wherein the fixed charge film is interposed at least between the first separation part and the second separation part.

15. The light detection device according to claim 14, further comprising:
a silicon oxide film interposed between the second separation part and the fixed charge film.

16. The light detection device according to claim 10, wherein the second material includes an insulating material.

17. The light detection device according to claim 10, wherein the second material includes a conductive material.

18. The light detection device according to claim 1, wherein, of a portion including silicon oxide and a portion including metal, the first separation part includes at least the portion including silicon oxide.

19. A method of manufacturing a light detection device, comprising:
forming a trench in a position to partition photoelectric conversion regions in a semiconductor layer from a side of an element forming surface thereof;
stacking, in the trench, a sacrificial layer and a first material in this order in a direction of thickness of the semiconductor layer, the first material being a material of which an etching rate relative to a selected etchant is lower than that of a material constituting the sacrificial layer;
exposing the sacrificial layer from a side of a light incident surface opposite to the side of the element forming surface;
removing the sacrificial layer while leaving the first material intact, by use of the selected etchant; and
embedding a material different from the material of the sacrificial layer into the trench from the side of the light incident surface.

20. Electronic equipment comprising:
a light detection device; and
an optical system that causes the light detection device to form an image of image light from a subject,
wherein the light detection device includes
a semiconductor layer having photoelectric conversion regions, one surface of the semiconductor layer forming a light incident surface, another surface of the semiconductor layer forming an element forming surface,
a trench positioned to partition the photoelectric conversion regions and penetrating the semiconductor layer in a direction of thickness thereof, and
a separation part formed in the trench and including a first separation part and a second separation part, the first separation part being positioned on a side of the light incident surface, the second separation part being positioned on a side of the element forming surface, and
a first surface of the second separation part on a side of the first separation part faces a first material.
